(19) Europäisches Patentamt
European Patent Office
Office européen des brevets

(11) EP 3 798 933 A1

(12) EUROPEAN PATENT APPLICATION

(43) Date of publication:
31.03.2021 Bulletin 2021/13

(51) Int Cl.:
G06N 3/12 (2006.01)   G06N 3/08 (2006.01)
G06F 30/30 (2020.01)

(21) Application number: 20195346.0

(22) Date of filing: 09.09.2020

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 17.09.2019 JP 2019168793

(71) Applicant: FUJITSU LIMITED
Kanagawa 211-8588 (JP)

(72) Inventors:
• TSUNODA, Yukito
Kawasaki-shi, Kanagawa 211-8588 (JP)
• ISHIHARA, Teruo
Kawasaki-shi, Kanagawa 211-8588 (JP)

(74) Representative: Haseltine Lake Kempner LLP
Cheapside House
138 Cheapside
London
EC2V 6BJ (GB)

(54) **INFORMATION PROCESSING APPARATUS, INFORMATION PROCESSING PROGRAM, AND INFORMATION PROCESSING METHOD**

(57) An information processing apparatus, a non-transitory computer-readable storage medium storing a program, and an information processing method are described. In an embodiment, provided is a solution to suppress increases of the amount of computational complexity of repetitions of each generation due to prediction with low precision. For example, an information processing apparatus includes: a memory configured to store program instructions; and a processor configured to execute the program instruction for evolutionary computation that searches an optimum value of the input parameters, the evolutionary computation being configured to repetitively calculate an objective function computed based on eigen solutions for input parameters, the program instructions including: a prediction processing; a first calculation processing; a second calculation processing; and a decision processing.

FIG. 1

**Description**

FIELD

The embodiments discussed herein are related to an information processing apparatus, an information processing program, and an information processing method.

BACKGROUND

A genetic algorithm (GA) has been known as one of evolutionary computation (EC). According to a genetic algorithm, for example, input values are converted to bit sequences and are generated randomly. Then, input values are selected (by keeping ones having a good characteristic) and crossing and variations are repeated thereon to find an optimum input value.

A method has been known which applies evolutionary computation with a genetic algorithm for designing an optimum structure. In order to acquire an optimum structure, performance evaluation is to be performed. In order to perform the performance evaluation, an intensity distribution corresponding to the designed structure is to be acquired. In order to acquire the intensity distribution, an eigen solution that satisfies an eigen solution condition is to be calculated.

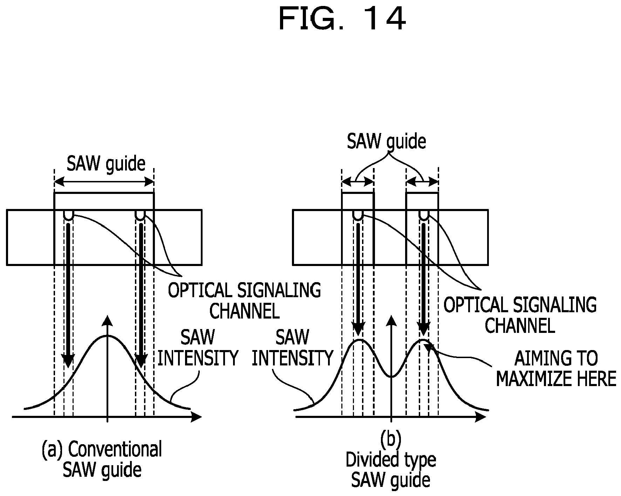

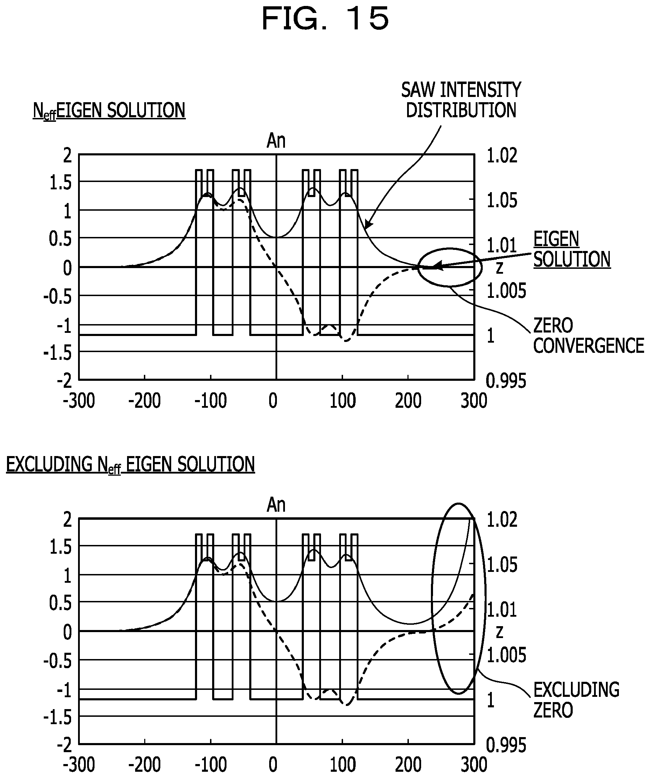

For example, a case where a structure having an arrangement of a surface acoustic wave (SAW) guide (signaling channel) with an optical SAW filter having a highest SAW application efficiency is to be acquired will be described with reference to FIGs. 14 and 15. FIG. 14 is a diagram illustrating a reference example of a SAW intensity distribution with an optical SAW filter having a highest SAW application efficiency. Referring to FIG. 14, two types of SAW intensity distributions where SAW signaling channels are arranged differently are illustrated. The arrangement of SAW signaling channels with a highest SAW intensity on optical signaling channels of SAW guides is acquired to acquire a structure with a highest SAW application efficiency.

The SAW intensity distribution is acquired based on Expression (1).

SAW intensity distribution $S(z)$:

$$S(z) = \begin{cases} A_i \mathrm{Exp}\{K_i(z-zc_i)\} + B_i \mathrm{Exp}\{-K_i(z-zc_i)\} & (N_i < \mathrm{Neff}) \\ A_i \mathrm{Cos}\{K_i(z-zc_i)\} + B_i \mathrm{Sin}\{-K_i(z-zc_i)\} & (N_i > \mathrm{Neff}) \end{cases}$$

$$K_i = k\sqrt{\left| N_i^2 - \mathrm{Neff}^2 \right|} \qquad i : \mathrm{Layer\ No.} \tag{1}$$

In order to acquire a SAW intensity distribution, an eigen solution that satisfies an eigen solution condition expressed by Expression (2) is to be calculated. In this example, in order to acquire a proper SAW intensity distribution, an eigen solution that converges to zero ($B_1 = 0$, $A_n = 0$) at both infinite distance is to be calculated.

Eigen Solution Condition

$$\begin{bmatrix} A_{n+1} \\ B_{n+1} \end{bmatrix} = \overline{M_{n+1}(zb_n)} \cdot M_n(zb_n) \cdot \overline{M_n(zb_{n-1})} \cdot M_{n-1}(zb_{n-1})$$

$$\cdots \overline{M_2(zb_1)} \cdot M_1(zb_1) \begin{bmatrix} A_1 \\ B_1 \end{bmatrix}$$

$$M_i(z) = \begin{bmatrix} P_i(z) & Q_i(z) \\ \dfrac{dP_i(z)}{dz} & \dfrac{dQ_i(z)}{dz} \end{bmatrix} \tag{2}$$

and $A_1 = 1$, $B_1 = 0$, $A_n = 0$

FIG. 15 is a diagram illustrating a reference example exhibiting a relationship between a SAW intensity distribution and an eigen solution. FIG. 15 illustrates a SAW intensity distribution of a structure in which four SAW signaling channels are arranged. Referring to the upper diagram of FIG. 15, a value of z that converges to zero ($B_1 = 0$, $A_n = 0$)

at both infinite distance is acquired as an eigen solution by changing the value of z for an eigen equation for deciding a SAW intensity distribution expressed by Expressions (1) and (2). In other words, for example, all points of z are searched to acquire an eigen solution. Referring to the lower diagram of FIG. 15, a value of z that converges to zero ($B_1 = 0$, $A_n = 0$) at both infinite distance is not acquired even by changing the value of z for the eigen equation for deciding a SAW intensity distribution expressed by Expressions (1) and (2). In other words, for example, an eigen solution for z is not acquired. Therefore, with the structure in which four SAW signaling channels are arranged, after an eigen solution is acquired, a SAW intensity distribution is decided, as in the upper diagram in FIG. 15.

After the eigen solution and intensity distribution corresponding to the structure are acquired, performance evaluation is performed on the structure based on the SAW intensity distribution for the structure. From the performance evaluations on the structures, new structures are selected from the structures. The structures of the next generation are generated by crossing and variations, and an optimum design structure is found.

A method has been proposed which predicts an eigen solution from input values representing structures by evolutionary computation with a genetic algorithm having a neural network (NN). According to the method, by using an NN predictor generated by causing the NN to learn preceding input values and eigen solutions accumulated by repetitions, an information processing apparatus predicts an approximate eigen solution from input values. The information processing apparatus starts a convergence calculation used for acquiring a precise eigen value from the approximate eigen value. The information processing apparatus searches in vicinity of the approximate eigen value and, if the prediction is right, an eigen solution may be efficiently found. If the prediction is wrong, the information processing apparatus searches the value of z that converges to zero ($B_1 = 0$, $A_n = 0$) at both infinite distance as the eigen solution by changing the value of the z for the eigen equation. In other words, for example, the information processing apparatus searches through all points for the eigen equation to find the eigen solution.

SUMMARY

[TECHNICAL PROBLEM]

However, the method that predicts an eigen solution from input values has a problem that it is difficult to determine when a change to the method using prediction is to be executed. In other words, for example, according to the method that predicts an eigen solution from input values, by using an NN predictor generated by causing the NN to learn previous input values and eigen solutions accumulated by repetitions, an information processing apparatus predicts an eigen solution from input values. Because, when data are not accumulated, the precision of prediction for an eigen solution by using the NN predictor is low, the information processing apparatus is to determine when a change to the method using the prediction is to be executed.

It is an object of one aspect of the present invention to suppress increases of the amount of computational complexity of repetitions of each generation due to prediction with low precision.

[SOLUTION TO PROBLEM]

According to an aspect of the embodiments, provided is an information processing apparatus includes: a memory configured to store program instructions; and a processor configured to execute the program instruction for an evolutionary computation that searches an optimum value of the input parameters, the evolutionary computation being configured to repetitively calculate an objective function computed based on eigen solutions for input parameters. In an example, the program instructions include: executing a prediction processing configured to predict a plurality of eigen solution candidates for a plurality of input parameters of a first generation based on combinations of the plurality of input parameters of the generation before the first generation and the plurality of eigen solutions calculated with a predetermined function from the plurality of input parameters; executing a first calculation processing configured to calculate a plurality of eigen solutions for each of a plurality of input parameters of the first generation; executing a second calculation processing configured to calculate a prediction hitting ratio by comparing calculated first plural eigen solutions for each of the plurality of input parameters of the first generation and predicted first plural eigen solution candidates for each of the plurality of input parameters of the first generation; and executing a decision processing configured to decide, based on the calculated prediction hitting ratio, whether predicted second plural eigen solution candidates are decided as second plural eigen solutions without executing the first calculation processing of calculating the eigen solutions for calculating the second plural eigen solutions for the plurality of input parameters of the second generation that is a generation after the first generation.

[ADVANTAGEOUS EFFECTS OF INVENTION]

According to one embodiment, increases of the amount of computational complexity of repetitions of each generation due to prediction with low precision may be suppressed.

BRIEF DESCRIPTION OF DRAWINGS

FIG. 1 is a functional block diagram illustrating a configuration of an information processing apparatus according to Embodiment 1;
FIG. 2 is a diagram illustrating the model generation according to Embodiment 1;
FIG. 3 is a diagram illustrating eigen solution prediction according to Embodiment 1;
FIG. 4 illustrates an example of a flowchart for hitting ratio evaluation according to Embodiment 1;
FIG. 5 illustrates an example of a flowchart for evolutionary computation according to Embodiment 1;
FIG. 6 illustrates an effect acquired when hitting ratio evaluation according to Embodiment 1 is applied to optical SAW filter design;
FIG. 7 is a diagram illustrating calculation techniques and the numbers of calculations;
FIG. 8 is a functional block diagram illustrating a configuration of an information processing apparatus according to Embodiment 2;
FIG. 9 illustrates an example of a case applying hitting ratio evaluation according to Embodiment 2;
FIG. 10 illustrates another example of a case applying hitting ratio evaluation according to Embodiment 2;
FIG. 11 illustrates an example of a flowchart for technique selection according to Embodiment 2;
FIG. 12 illustrates another example using the eigen solution prediction according to Embodiments 1 and 2;
FIG. 13 illustrates an example of a computer that executes an information processing program;
FIG. 14 illustrates a reference example of a SAW intensity distribution with an optical SAW filter having a highest SAW application efficiency;
FIG. 15 illustrates a reference example exhibiting a relationship between a SAW intensity distribution and an eigen solution;
FIG. 16 illustrates a reference example of a flowchart for structure design with evolutionary computation;
FIG. 17 is a supplementary diagram for description of the structure design with evolutionary computation;
FIG. 18 illustrates a reference example of a flowchart for model generation when an eigen solution is predicted; and
FIG. 19 illustrates a reference example of a flowchart for evolutionary computation when an eigen solution is predicted by using a model.

DESCRIPTION OF EMBODIMENT(S)

Embodiments of an information processing apparatus, an information processing program and an information processing method disclosed herein will be described in detail with reference to drawings. In embodiments of the present invention, an optimum arrangement (structure design) of optical signaling channels with an optical SAW filter having a highest SAW application efficiency is to be acquired by evolutionary computation. However, the present invention is not limited to the embodiments.

[Reference Example of Flowchart for Structure Design with Evolutionary Computation When All Point Search Is Performed]

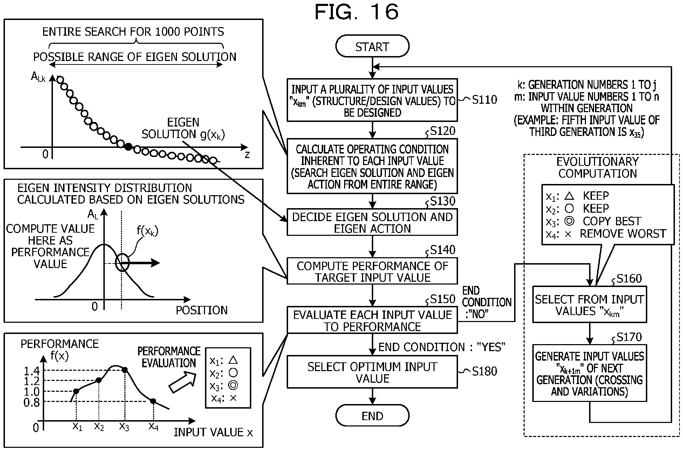

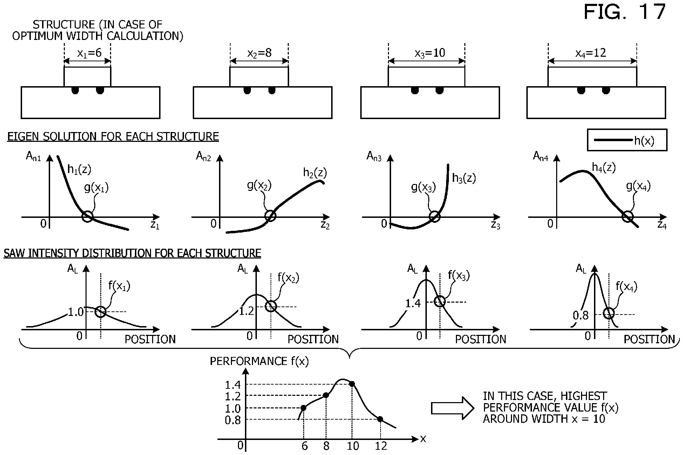

First, a reference example of a flowchart for structure design with evolutionary computation when all point search is performed will be described with reference to FIG. 16. FIG. 16 illustrates a reference example of a flowchart for structure design with evolutionary computation when all point search is performed. The flowchart in FIG. 16 will be described with reference to the supplementary drawing in FIG. 17.
As illustrated in FIG. 16, an information processing apparatus obtains structures to be designed as input values $x_{km}$ (S110). k indicates a generation, and m indicates an input value number within the generation. For example, as illustrated in the first row in FIG. 17, in order to calculate an optimum width, input values within a certain generation are "6" as $x_1$, "8" as $x_2$, "10" as $x_3$, and "12" as $x_4$.
The information processing apparatus calculates an operating condition inherent to each of the input values $x_{km}$ (step S120). In other words, for example, when $A_1 = 1$ and $B_1 = 0$ of the eigen solution condition in Expression (2) are input, a function for acquiring $A_n$ is expressed as h(z). Because $A_n$ is h(z) and because of the condition $A_n = 0$, a condition acquired by solving the equation resulting $A_n$ or h(z) equal to zero is an eigen solution g(z). Because h(z) depends on the structure, it varies in accordance with the input value $x_{km}$. If the possible range of the eigen solution is 1000 points that z may take, the information processing apparatus searches eigen solutions and eigen actions for all of the 1000 points.

The information processing apparatus decides eigen solutions and eigen actions (step S130). In other words, for example, the point z resulting in h(z) equal to zero is decided as an eigen solution g(z). For example, as illustrated in the second row of FIG. 17, eigen solutions $g(x_1)$, $g(x_2)$, $g(x_3)$, and $g(x_4)$ for the input values of the structures are decided. As illustrated in the third row of FIG. 17, the SAW intensity distributions for the input values of the structures are decided as eigen actions. Each of the SAW intensity distributions is represented by a graph having a position of an optical signaling channel as an x axis and a SAW intensity as a y axis. The SAW intensity distribution as an eigen action is decided based on an eigen solution.

The information processing apparatus calculates a performance of a target input value (step S140). For example, as illustrated in the third row of FIG. 17, the information processing apparatus calculates, as a performance value, a SAW intensity corresponding to the position of the optical signaling channel of each of the structures from the SAW intensity distribution for the input value being each of the structures. When the input value is $x_1$, "1.0" is calculated as a performance value $f(x_1)$. When the input value is $x_2$, "1.2" is calculated as a performance value $f(x_2)$. When the input value is $x_3$, "1.4" is calculated as a performance value $f(x_3)$. When the input value is $x_4$, "0.8" is calculated as a performance value $f(x_4)$.

The information processing apparatus evaluates the performances corresponding to the input values (step S150). For example, as illustrated in the fourth row of FIG. 17, the performance value is 1.0 for the input value $x_1$ (= 6). For the input value $x_2$ (= 8), the performance value is 1.2. For the input value $x_3$ (= 10), the performance value is 1.4. For the input value $x_4$ (= 12), the performance value is 0.8. Therefore, in this case, the part in which the width indicated by x is around "10" is evaluated as producing the best performance value f(x).

If the end condition is not satisfied, the information processing apparatus selects the input values based on the evaluation results (step S160). For example, the information processing apparatus keeps the input value $x_3$ (= 10), the input value $x_1$ (= 6) and the input value $x_2$ (= 8) having good performance values, and removes the input value $x_4$ (= 12) with the worst performance value.

The information processing apparatus generates input values $x_{k+1m}$ of the next generation (step S170). For example, the information processing apparatus crosses the selected input values and changes the crossed input values to generate the input values of the next generation. The information processing apparatus evaluates the performances for the input values of the next generation.

If the end condition is satisfied, the information processing apparatus selects an optimum input value based on the evaluation result (step S180).

In the processing of the evolutionary computation for selecting such an optimum structure design, the information processing apparatus calculates an eigen solution for acquiring a SAW intensity distribution. In this case, the information processing apparatus searches an eigen solution for all points in the possible range of the eigen solution. The information processing apparatus therefore takes a large amount of computational complexity for acquiring an eigen solution, which means that the entire amount of computational complexity of evolutionary computation may not be reduced.

[Reference Example of Flowchart for Model Generation for Prediction]

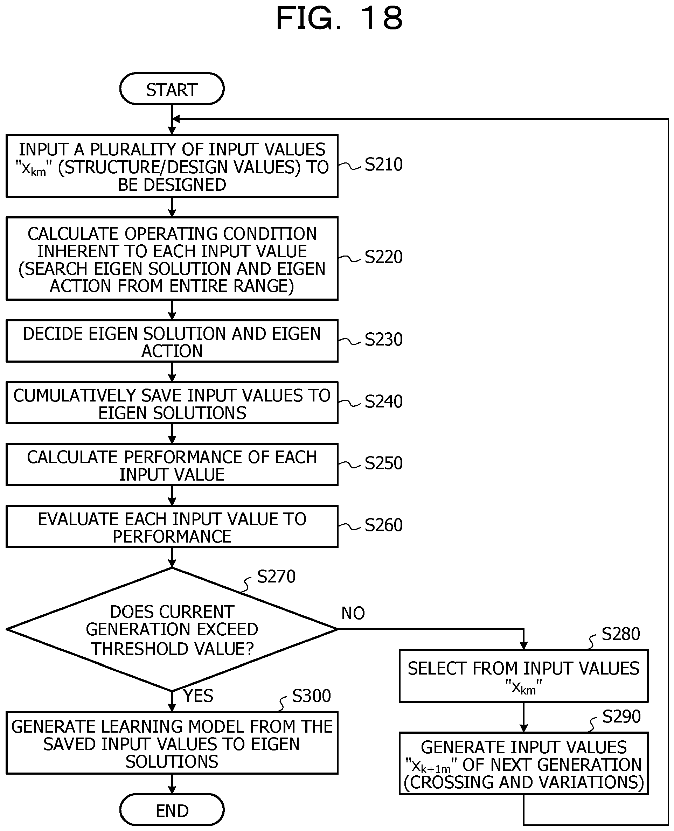

Next, a reference example of a flowchart for generating a model (NN predictor) to be used for predicting an eigen solution will be described with reference to FIG. 18. FIG. 18 illustrates a reference example of a flowchart for model generation when an eigen solution is predicted. The initial value of the generation k is assumed to be "1".

As illustrated in FIG. 18, an information processing apparatus inputs a plurality of input values "$x_{km}$" to be designed (structures/design values) (step S210).

The information processing apparatus calculates an operating condition inherent to each of the input values "$x_{km}$" (step S220). In other words, for example, when $A_1 = 1$ and $B_1 = 0$ of the eigen solution condition in Expression (2) are input, a function for acquiring $A_n$ is expressed as h(z). Because $A_n$ is h(z) and because of the condition $A_n = 0$, the information processing apparatus solves the equation resulting in $A_n$ or h(z) equal to zero for all possible points of z. The condition for solving the equation resulting in $A_n$ or h(z) equal to zero is an eigen solution g(z) for all possible points of z. Because h(z) depends on the structure, it varies in accordance with the input value $x_{km}$. If the possible range of the eigen solution is 1000 points that z may take, the information processing apparatus searches eigen solutions and eigen actions for all of the 1000 points.

The information processing apparatus decides the eigen solution and the eigen action for each of the input values (step S230). In other words, for example, the point z resulting in h(z) equal to zero is decided as an eigen solution g(z). For example, the information processing apparatus decides, as an eigen solution, the value of z with which the equation h(z) is solved to zero for each of the input values. Based on Expression (1), the information processing apparatus calculates, as an eigen action, a SAW intensity distribution corresponding to the decided eigen solution. The information processing apparatus substitutes the eigen solution for Neff in Expression (1) to calculate a SAW intensity distribution corresponding to the eigen solution.

The information processing apparatus cumulatively saves the eigen solutions for the input values in a predetermined storage unit (step S240).

The information processing apparatus calculates a performance of each of the input values (step S250). For example, the information processing apparatus calculates, as a performance value, a SAW intensity corresponding to the position of the optical signaling channel of each of the structures indicated by the input values from the SAW intensity distribution for each of the input values. The information processing apparatus evaluates the performances of the input values based on the performance values of the input values (step S260).

The information processing apparatus determines whether the current generation exceeds a threshold value or not (step S270). If it is determined that the current generation does not exceed the threshold value (No in step S270), the information processing apparatus selects input values from the current input values "$x_{km}$" based on the evaluation results (step S280).

The information processing apparatus generates input values "$x_{k+1m}$" of the next generation (step S290). For example, the evolutionary computation unit 14 crosses the selected input values and changes the crossed input value to generate the input values of the next generation. The information processing apparatus moves to step S210 for processing on the next generation.

On the other hand, if it is determined that the current generation exceeds the threshold value (Yes in step S270), the information processing apparatus generates a learning model that predicts the range in which eigen solutions for the input values exist from the eigen solutions for the stored input values (step S300). The learning model corresponds to the model or the NN predictor. The model generation processing ends. In this disclosure, the term "a learning model" may be referred to as "a learned model", "a trained model", "a model", and the like.

[Reference Example of Flowchart for Structure Design with Evolutionary Computation When Prediction Is Performed]

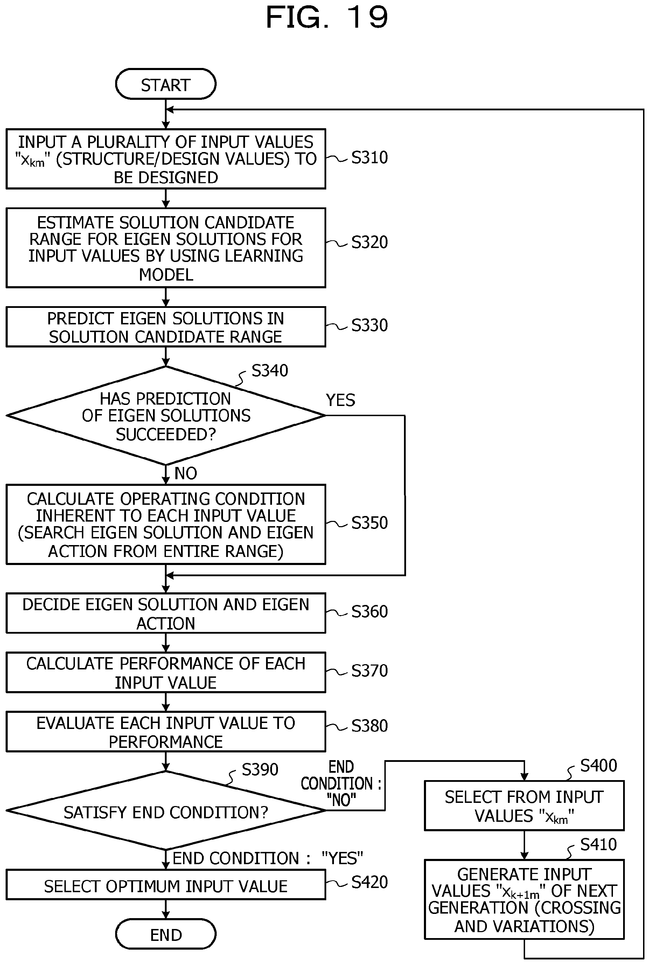

Next, a reference example of a flowchart for structure design with evolutionary computation when an eigen solution is predicted by using the model will be described with reference to FIG. 19. FIG. 19 illustrates a reference example of a flowchart for evolutionary computation when an eigen solution is predicted by using the model. The initial value of the generation k is assumed to be the threshold value used for the model generation + 1.

As illustrated in FIG. 19, an information processing apparatus inputs a plurality of input values "$x_{km}$" to be designed (structures/design values) (step S310).

By using the learning model (i.e., the trained model), the information processing apparatus estimates a solution candidate range for eigen solutions for the input values (step S320). The information processing apparatus predicts an eigen solution in the solution candidate range (step S330). For example, when $A_1 = 1$ and $B_1 = 0$ of the eigen solution condition in Expression (2) are input, the information processing apparatus calculates the function h(z) for acquiring $A_n$ for each of the input values. The information processing apparatus solves the equation resulting in $A_n$ or h(z) equal to zero with respect to points of z in the estimated solution candidate range because of the condition of $A_n = 0$ of the eigen solution condition in Expression (2) for each of the input values to predict an eigen solution. In other words, for example, the eigen solution predicting unit 163 substitutes values of z within the eigen solution range sequentially for the equation h(z) and predicts the value of z resulting in zero as an eigen solution.

The information processing apparatus determines whether the eigen solution prediction has succeeded in the solution candidate range or not (step S340). If it is determined that the eigen solution prediction has succeeded in the solution candidate range (Yes in step S340), the information processing apparatus moves to step S360.

On the other hand, if it is determined that the eigen solution prediction has not succeeded in the solution candidate range (No in step S340), the information processing apparatus calculates eigen operating conditions for the input values "$x_{km}$" (step S350). For example, when $A_1 = 1$ and $B_1 = 0$ of the eigen solution condition in Expression (2) are input, the information processing apparatus calculates the function h(z) for acquiring $A_n$ for each of the input values. The information processing apparatus searches for an eigen solution by solving the equation resulting in $A_n$ or h(z) equal to zero with respect to all possible points of z because of the condition of $A_n = 0$ of the eigen solution condition in Expression (2) for each of the input values. The information processing apparatus moves to step S360.

The information processing apparatus decides the eigen solution and the eigen action for each of the input values (step S360). For example, the information processing apparatus decides, as an eigen solution, the value of z with which the equation h(z) is solved to zero for each of the input values. Based on Expression (1), the information processing apparatus calculates, as an eigen action, a SAW intensity distribution corresponding to the decided eigen solution. The HPC calculating unit 121 substitutes the eigen solution for Neff in Expression (1) to calculate a SAW intensity distribution corresponding to the eigen solution.

The information processing apparatus calculates a performance of each of the input values (step S370). For example, the information processing apparatus calculates, as a performance value, a SAW intensity corresponding to the position of the optical signaling channel of each of the structures indicated by the input values from the SAW intensity distribution for each of the input values. The information processing apparatus evaluates the performances of the input values based on the performance values of the input values (step S380).

The information processing apparatus determines whether an end condition is satisfied or not (step S390). If it is determined that the end condition is not satisfied (No in step S390), the information processing apparatus selects input values from the current input values "$x_{km}$" based on the evaluation results (step S400).

The information processing apparatus generates input values "$x_{k+1m}$" of the next generation (step S410). For example, the information processing apparatus crosses the selected input values and changes the crossed input values to generate the input values of the next generation. The information processing apparatus moves to step S310 for processing on the next generation.

On the other hand, if it is determined that the end condition is satisfied (Yes in step S390), the information processing apparatus selects an optimum input value based on the results of the performance evaluations for the input values (step S420). The evolutionary computation processing ends.

In the processing of the evolutionary computation for selecting such an optimum structure design by using the model, the information processing apparatus predicts a solution candidate range of an eigen solution for acquiring a SAW intensity distribution by using the model. When the model has low precision, the information processing apparatus does not often succeed in the eigen solution prediction in the solution candidate range of an eigen solution, which is predicted by the model. Therefore, an eigen solution is searched through all points in the possible range of the eigen solution. The information processing apparatus therefore takes a large amount of computational complexity of the repetitions for each generation for calculating an eigen solution by the prediction with low precision, which means that the entire amount of computational complexity of evolutionary computation may not be reduced.

Accordingly, according to the following embodiments, an information processing apparatus will be described which may reduce the amount of computational complexity of evolutionary computation when an eigen solution is predicted by using a model.

[Embodiment 1]

[Configuration of Information Processing Apparatus]

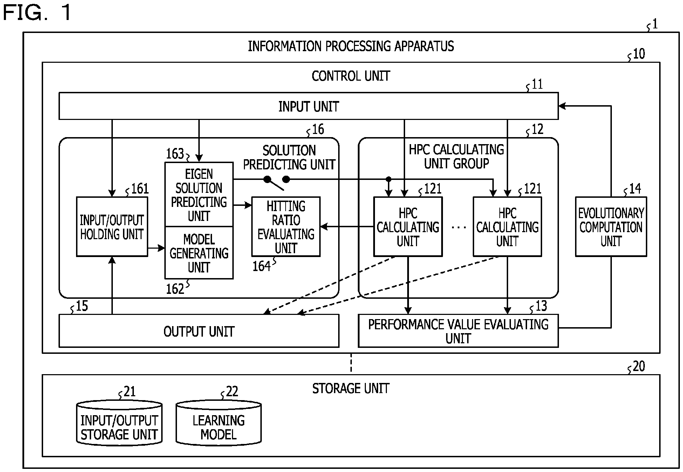

FIG. 1 is a functional block diagram illustrating a configuration of an information processing apparatus according to Embodiment 1. An information processing apparatus 1 illustrated in FIG. 1 generates a model that predicts eigen solution candidates (solution candidate range) based on combinations of a plurality of input values (input parameters) and respectively calculated correct eigen solutions in the generation preceding to a first generation in evolutionary computation that searches an optimum value of input values representing structures. The information processing apparatus 1 calculates respectively correct eigen solutions from a plurality of input values of the first generation. The information processing apparatus 1 compares the calculated correct eigen solutions and the eigen solution candidates predicted by the model for the plurality of input values of the first generation and calculates prediction hitting ratio. Based on the calculated prediction hitting ratio, the information processing apparatus 1 decides whether the prediction with the eigen solution candidates is to be executed or not.

The information processing apparatus 1 has a control unit 10 and a storage unit 20.

The control unit 10 is an electronic circuit such as a central processing unit (CPU). The control unit 10 has an internal memory for storing programs defining various processing procedures or control data, and executes various processing using the programs and data. The control unit 10 has an input unit 11, a high-performance computing (HPC) calculating unit group 12, a performance value evaluating unit 13, an evolutionary computation unit 14, an output unit 15, and a solution predicting unit 16.

The storage unit 20 is, for example, a semiconductor memory device such as a random-access memory (RAM) or a flash memory, or a storage device such as a hard disk or an optical disk. The storage unit 20 has an input/output storage unit 21 and a learning model 22 (i.e., a trained model 22).

The input/output storage unit 21 stores an input value and an output value (performance value) in the past and an eigen solution in association. The input/output storage unit 21 is stored by an input/output holding unit 161, which will be described below.

The learning model 22 is a resulting model of learning for acquiring a range (solution candidate range) of an eigen solution corresponding to a new input value by using an input value in the past and an eigen solution corresponding to the input value. The learning model 22 is trained by a method using a neural network (NN), for example. The learning model 22 is generated by a model generating unit 162, which will be described below.

The input unit 11 outputs a plurality of input values to be designed and to be used for generating the learning model 22 to an HPC calculating unit 121, which will be described below, and the input/output holding unit 161, which will be described below. The input unit 11 outputs a plurality of input values to be designed for predicting an eigen solution by using the learning model 22 to an eigen solution predicting unit 163, which will be described below.

The HPC calculating unit group 12 has a plurality of HPC calculating units 121. Hereinafter, one HPC calculating unit 121 will be described.

The HPC calculating unit 121 receives an input value to be designed of a predetermined generation and acquires an eigen solution satisfying an eigen solution condition for the input value. In other words, for example, the HPC calculating unit 121 searches an eigen solution satisfying an eigen solution condition (Expression (2)) for an input value from an entire possible range of the eigen solution. Hereinafter, the search for an eigen solution satisfying an eigen solution condition from an entire range will be called "entire range search". For example, representing a function for acquiring $A_n$ by h(z) when $A_1 = 1$ and $B_1 = 0$ in the eigen solution condition of Expression (2) are input, the HPC calculating unit 121 solves an equation resulting in $A_n$ or h(z) equal to zero because of a condition of $A_n = 0$. The condition for solving the equation resulting in zero is an eigen solution g(z). The possible range of the eigen solution is all possible points of z. Therefore, the HPC calculating unit 121 searches an eigen solution resulting in h(z) equal to zero at all possible points of z. The HPC calculating unit 121 outputs the eigen solution for the input value, which is searched by the entire range search, to an output unit 15, which will be described below.

In addition, the HPC calculating unit 121 calculates a SAW intensity distribution (eigen action) as an objective function based on the eigen solution. For example, the HPC calculating unit 121 calculates a SAW intensity distribution corresponding to the eigen solution based on Expression (1). The HPC calculating unit 121 substitutes the eigen solution for Neff in Expression (1) to calculate a SAW intensity distribution corresponding to the eigen solution. The HPC calculating unit 121 calculates a SAW intensity corresponding to an input value as a performance value by using the SAW intensity distribution for the input value. The HPC calculating unit 121 outputs the performance value for the input value to the output unit 15, which will be described below, and the performance value evaluating unit 13, which will be described below.

The performance value evaluating unit 13 evaluates the performance of each input value based on the performance value corresponding to each input value. The performance value evaluating unit 13 finally selects an optimum input value based on results of performance evaluations on the input values.

The evolutionary computation unit 14 selects input values to be kept from a plurality of input values based on the evaluation results of the performances of input values. The evolutionary computation unit 14 crosses the selected input values and changes the crossed input value to generate the input values of the next generation. The evolutionary computation unit 14 outputs the input values of the next generation to the input unit 11.

The output unit 15 outputs the eigen solutions and performance values for input values, which are output from the HPC calculating units 121 and searched by the entire range search to the input/output holding unit 161, which will be described below.

The solution predicting unit 16 has the input/output holding unit 161, a model generating unit 162, an eigen solution predicting unit 163, and a hitting ratio evaluating unit 164. The eigen solution predicting unit 163 is an example of a prediction step and a first calculation step. The hitting ratio evaluating unit 164 is an example of a second calculation step and a decision step.

The input/output holding unit 161 holds the eigen solutions and performance values for input values, which are searched by the entire range search, in the input/output storage unit 21.

The model generating unit 162 generates the learning model 22 configured to predict the range in which the eigen solutions satisfying an eigen solution condition for input values exist based on eigen solutions for the input values, which are searched by the entire range search. For example, the model generating unit 162 causes a neural network (NN) to learn combinations of input values and eigen solutions, which are stored in the input/output storage unit 21, and generates the learning model 22 configured to predict the range of the eigen solution for an input value. The combinations of input values and eigen solutions, which are used for generating the learning model 22, may be the combinations of a generation before a generation for which eigen solutions are to be predicted. The amount of computational complexity for predicting a range of an eigen solution for input values by the model generating unit 162 is lower than the amount of computational complexity for acquiring an eigen solution satisfying an eigen solution condition for input values by the entire range search.

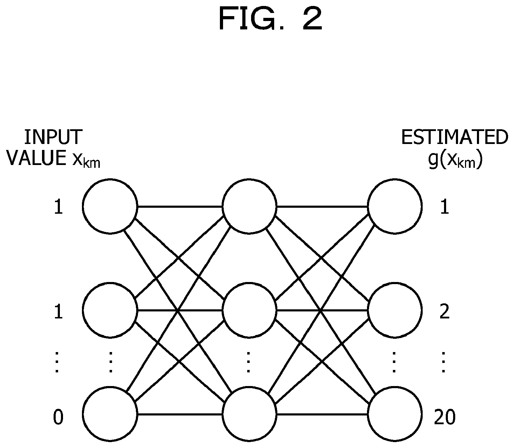

The model generation by the model generating unit 162 will be described with reference to FIG. 2. FIG. 2 is a diagram illustrating the model generation according to Embodiment 1. As illustrated in FIG. 2, the model generating unit 162 causes an NN to learn input values $x_{km}$ and eigen solutions $g(x_{km})$ and thus generates the learning model 22 that predicts an estimation $g(x_{km})$ for an input value. The term "estimation $g(x_{km})$" refers to a range (solution candidate range) of an eigen solution. k indicates a generation, and m indicates an input value number within the generation.

Referring back to FIG. 1, when prediction of eigen solution candidates is applied, the eigen solution predicting unit 163 uses the learning model 22 to predict the range (solution candidate range) in which the eigen solution for an input value exists of the corresponding generation. When the prediction of eigen solution candidates is not applied, the eigen solution predicting unit 163 causes the HPC calculating units 121 to calculate to perform the entire range search for an eigen solution for input values. Whether the prediction of eigen solution candidates is to be applied or not is determined by the hitting ratio evaluating unit 164, which will be described below.

For a generation for which hitting ratio evaluation is to be executed, the eigen solution predicting unit 163 uses the learning model 22 to predict the range (solution candidate range) in which the eigen solution for input values exists of the corresponding generation. The generation for which hitting ratio evaluation is to be executed may be predetermined.

When prediction of eigen solution candidates is to be applied or for a generation for which hitting ratio evaluation is to be executed, the eigen solution predicting unit 163 searches an eigen solution for the input values, which satisfies an eigen solution condition for the input values, in the predicted eigen solution range (solution candidate range). Hereinafter, the search for an eigen solution satisfying an eigen solution condition from an eigen solution range will be called "partial range search".

For example, representing a function for acquiring $A_n$ by $h(z)$ when $A_1 = 1$ and $B_1 = 0$ in the eigen solution condition of Expression (2) are input, the eigen solution predicting unit 163 solves an equation resulting in $A_n$ or $h(z)$ equal to zero because of a condition of $A_n = 0$. The condition for solving the equation resulting in zero is an eigen solution $g(z)$. The range of z for solving the equation resulting in zero is the predicted eigen solution range (partial range). The eigen solution predicting unit 163 searches an eigen solution at points within the predicted eigen solution range (partial range). In other words, for example, the eigen solution predicting unit 163 substitutes values of z within the eigen solution range sequentially for the equation $h(z)$ and predicts the value of z resulting in zero as a precise eigen solution.

If the eigen solution prediction succeeds, the eigen solution predicting unit 163 outputs the eigen solution along with the input value to the HPC calculating unit 121. This is for causing the HPC calculating unit 121 to calculate a SAW intensity distribution (eigen action) of the eigen solution for the input value and to calculate the performance value for the input value. On the other hand, if the eigen solution prediction fails, the eigen solution predicting unit 163 outputs the input value for the eigen solution resulting from the prediction failure to the HPC calculating unit 121. This is for causing the HPC calculating unit 121 to acquire an eigen solution for the input value by the entire range search.

[Description of Eigen Solution Prediction]

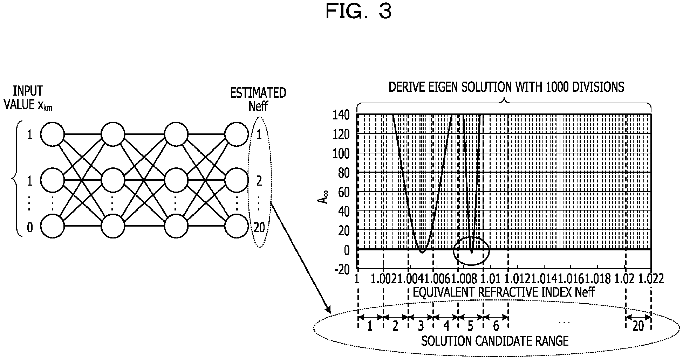

The eigen solution prediction by the eigen solution predicting unit 163 will be described with reference to FIG. 3. FIG. 3 is a diagram illustrating eigen solution prediction according to Embodiment 1. In FIG. 3, it is assumed that the solution candidate range is divided into 20 ranges for 500 points acquired by dividing 1000 points by 20.

First, by using the learning model 22 illustrated on the left side of FIG. 3, the eigen solution predicting unit 163 predicts a solution candidate range for input values $x_{km}$.

Next, as illustrated on the right side of FIG. 3, the eigen solution predicting unit 163 searches an eigen solution for an input value, which satisfies the eigen solution condition for the input value, within the predicted solution candidate range. It is assumed here that the predicted solution candidate range is "5". Within the range indicated by the solution candidate range "5", the eigen solution predicting unit 163 solves an equation in which the function $h(z)$ for acquiring $A_n$ with input of $A_1 = 1$ and $B_1 = 0$ of the eigen solution condition of Expression (2) results in zero because of a condition of $A_n = 0$. In other words, for example, the eigen solution predicting unit 163 substitutes values of z within the range indicated by the solution candidate range "5" for the equation $h(z)$. If the function $h(z)$ results in zero with one of z values within the solution candidate range or if the eigen solution prediction succeeds, the eigen solution predicting unit 163 predicts the z value with which the function $h(z)$ results in zero as a precise eigen solution. Thus, compared with the case of the entire range search that searches all points with a possible range of a solution, the eigen solution predicting unit 163 may search only in the 1/20 range, resulting in reduction of the amount of computational complexity to 1/20 and increasing the processing speed.

From the result that the function $h(z)$ is not equal to zero when the function $h(z)$ is not equal to zero with a z value within the solution candidate range, the eigen solution predicting unit 163 obtains a result that an eigen solution may not have been obtained from the range or the prediction of an eigen solution has failed. Therefore, in this case, the HPC calculating unit 121 may be caused to further acquire an eigen solution by the entire range search.

Referring back to FIG. 1, the hitting ratio evaluating unit 164 evaluates a hitting ratio of the eigen solution prediction using the learning model 22.

For example, the hitting ratio evaluating unit 164 compares eigen solution candidates (solution candidate range) predicted by the eigen solution predicting unit 163 and the calculated precise eigen solutions for a plurality of input values of a generation to be evaluated and calculates a prediction hitting ratio. The expression "precise eigen solution" here refers to an eigen solution found by partial range search or found by entire range search through the solution candidate range predicted by the learning model 22.

As an example, the hitting ratio evaluating unit 164 selects a plurality of input values of a generation to be evaluated one by one. The hitting ratio evaluating unit 164 compares the predicted solution candidate range and a precise input value for the selected input value. If the precise eigen solution is found by the partial range search through the solution candidate range, the hitting ratio evaluating unit 164 evaluates as that the prediction is right. If the prediction is evaluated as being right, the hitting ratio evaluating unit 164 counts 1 as a hitting variable. When the hitting ratio evaluating unit 164 compares the predicted solution candidate range and the precise eigen solution for the selected input value and if the precise eigen solution is not found by the partial range search through the solution candidate range but is found by the entire range search, the hitting ratio evaluating unit 164 evaluates as that the prediction is wrong. If the prediction is evaluated as being wrong, the hitting ratio evaluating unit 164 counts nothing for the hitting variable.

After all of the plurality of input values of the generation to be evaluated are selected, the hitting ratio evaluating unit 164 calculates a prediction hitting ratio by using the hitting variable and the number of the input values of the target generation. The learning model 22 (i.e., the trained model 22) may be, for example, a model using input values of the first generation to the one previous generation of the generation to be evaluated or a model using input values of a plurality of immediately close generations that are generations before the generation to be evaluated.

The hitting ratio evaluating unit 164 determines whether the prediction hitting ratio is equal to or higher than a threshold value or not for the plurality of input values of the generation to be evaluated. The threshold value is 60%, for example, but the embodiment is not limited thereto. If the prediction hitting ratio is equal to or higher than the threshold value, the hitting ratio evaluating unit 164 decides to apply the prediction with the eigen solution candidates. If the prediction hitting ratio is lower than the threshold value, the hitting ratio evaluating unit 164 decides not to apply the prediction with the eigen solution candidates.

[Flowchart for Hitting Ratio Evaluation]

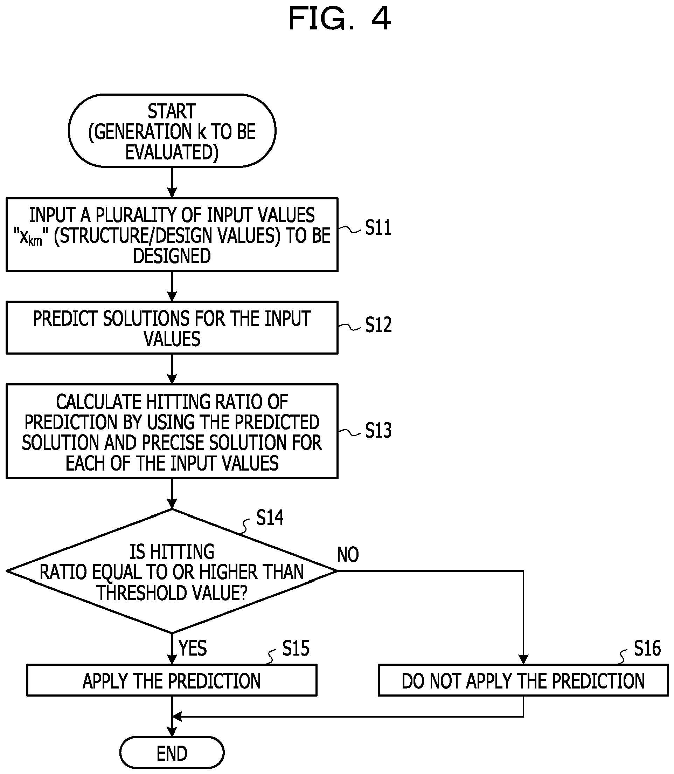

FIG. 4 illustrates an example of a flowchart for hitting ratio evaluation according to Embodiment 1. A generation k is to be evaluated for a hitting ratio. It is assumed that the learning model 22 is generated by the model generating unit 162.

As illustrated in FIG. 4, the eigen solution predicting unit 163 inputs a plurality of input values "$x_{km}$" to be designed (structures/design values) (step S11).

The eigen solution predicting unit 163 predicts eigen solutions for the input values (step S12). For example, for each of input values that have been input, the eigen solution predicting unit 163 estimates a solution candidate range for eigen solutions for the input values by using the learning model 22. When $A_1 = 1$ and $B_1 = 0$ of the eigen solution condition in Expression (2) are input, the eigen solution predicting unit 163 calculates the function h(z) for acquiring $A_n$ for each of the input values. The eigen solution predicting unit 163 solves the equation resulting in $A_n$ or h(z) equal to zero with respect to points of z in the estimated solution candidate range because of the condition of $A_n = 0$ of the eigen solution condition in Expression (2) for each of the input values to acquire an eigen solution. In other words, for example, the eigen solution predicting unit 163 substitutes values of z within the eigen solution range sequentially for the equation h(z) and predicts the value of z resulting in zero as a precise eigen solution. If the eigen solution prediction fails, the eigen solution predicting unit 163 outputs the input value to the HPC calculating unit 121 and causes the HPC calculating unit 121 to acquire a precise eigen solution by the entire range search.

Next, the hitting ratio evaluating unit 164 computes a hitting ratio of the prediction by using a predicted eigen solution and a precise eigen solution for each input value (step S13). For example, the hitting ratio evaluating unit 164 compares eigen solution candidates (solution candidate range) predicted by the eigen solution predicting unit 163 and the calculated precise eigen solutions for a plurality of input values and calculates a prediction hitting ratio.

The hitting ratio evaluating unit 164 determines whether the hitting ratio is equal to or higher than a threshold value (step S14). If it is determined that the hitting ratio is equal to or higher than the threshold value (Yes in step S14), the hitting ratio evaluating unit 164 decides to apply the prediction using the learning model 22 for the subsequent generations (step S15). The hitting ratio evaluating unit 164 ends the hitting ratio evaluation.

On the other hand, if it is decided that the hitting ratio is not equal to or higher than the threshold value (No in step S14), the hitting ratio evaluating unit 164 decides not to apply the prediction using the learning model 22 for the subsequent generations (step S16). The hitting ratio evaluating unit 164 ends the hitting ratio evaluation.

[Flowchart for Evolutionary Computation]

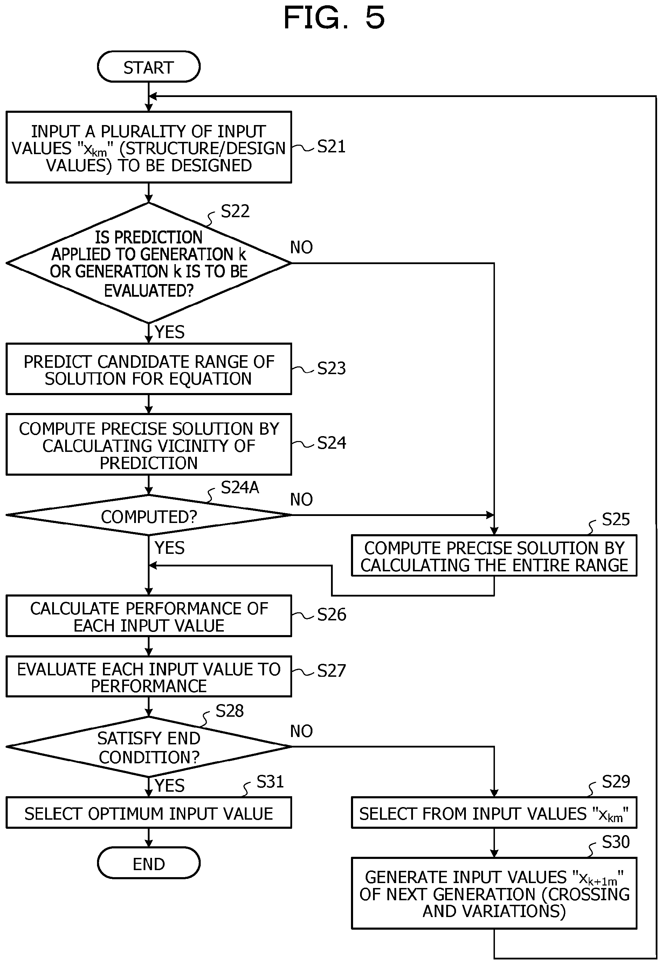

FIG. 5 illustrates an example of a flowchart for evolutionary computation according to Embodiment 1.

As illustrated in FIG. 5, the input unit 11 inputs a plurality of input values "$x_{km}$" to be designed (structures/design values) (step S21).

The eigen solution predicting unit 163 determines whether the generation k is a generation applying the prediction or the generation to be evaluated (step S22). If it is determined that the generation k is not a generation applying the prediction and is not the generation to be evaluated (No in step S22), the eigen solution predicting unit 163 moves to step S25 to perform the entire range search.

On the other hand, if the generation k is a generation applying the prediction or the generation to be evaluated (Yes in step S22), the eigen solution predicting unit 163 predicts a solution candidate range for the solution of the eigen equation by using the learning model 22 for each of the input values that have been input (step S23).

The eigen solution predicting unit 163 computes in vicinity of the prediction and calculates a precise solution (step S24). For example, when $A_1 = 1$ and $B_1 = 0$ of the eigen solution condition in Expression (2) are input, the eigen solution predicting unit 163 calculates the function h(z) for acquiring $A_n$ for each of the input values. The eigen solution predicting unit 163 solves the equation resulting in $A_n$ or h(z) equal to zero with respect to points of z in the estimated solution candidate range because of the condition of $A_n = 0$ of the eigen solution condition in Expression (2) for each of the input values to predict an eigen solution. In other words, for example, the eigen solution predicting unit 163 substitutes values of z within the eigen solution range sequentially for the equation h(z) and determines the value of z resulting in zero as a precise eigen solution.

The eigen solution predicting unit 163 determines whether an eigen solution has been calculated or not (step S24A). If it is determined that an eigen solution has been calculated (Yes in step S24A), the eigen solution predicting unit 163 moves to step S26.

On the other hand, if it is determined that an eigen solution has not been calculated (No in step S24A), the eigen solution predicting unit 163 moves to step S25 to perform the entire range search.

In step S25, the HPC calculating unit 121 computes in the entire range to calculate a precise solution (step S25). For example, when $A_1 = 1$ and $B_1 = 0$ of the eigen solution condition in Expression (2) are input, the HPC calculating unit 121 calculates the function h(z) for acquiring $A_n$ for each of the input values. The HPC calculating unit 121 solves the equation resulting in $A_n$ or h(z) equal to zero with respect to all possible points of z because of the condition of $A_n$ = 0 of the eigen solution condition in Expression (2) for each of the input values to predict an eigen solution. In other words, for example, the HPC calculating unit 121 substitutes values of z within the eigen solution range sequentially for the equation h(z) and determines the value of z resulting in zero as a precise eigen solution. The HPC calculating unit 121 moves to step S26.

In step S26, the performance value evaluating unit 13 calculates the performances of the input values (step S26). For example, based on Expression (1), the performance value evaluating unit 13 calculates, as an eigen action, a SAW intensity distribution corresponding to the decided eigen solution. The performance value evaluating unit 13 substitutes the eigen solution for Neff in Expression (1) to calculate a SAW intensity distribution corresponding to the eigen solution. The performance value evaluating unit 13 calculates, as a performance value, a SAW intensity corresponding to the position of the optical signaling channel of each of the structures indicated by the input values from the SAW intensity distribution for each of the input values.

The performance value evaluating unit 13 evaluates the performances of the input values based on the performance values of the input values (step S27).

The performance value evaluating unit 13 determines whether an end condition is satisfied or not (step S28). If it is determined that the end condition is not satisfied (No in step S28), the evolutionary computation unit 14 selects input values from the current input values "$x_{km}$" based on the evaluation results (step S29).

The evolutionary computation unit 14 generates input values "$x_{k+1m}$" of the next generation (step S30). For example, the evolutionary computation unit 14 crosses the selected input values and changes the crossed input value to generate the input values of the next generation. The evolutionary computation unit 14 moves to step S21 for processing on the next generation.

On the other hand, if it is determined that the end condition is satisfied (Yes in step S28), the performance value evaluating unit 13 selects an optimum input value based on the results of the performance evaluations for the input values (step S31). The evolutionary computation processing ends.

[Description of Hitting Ratio Evaluation]

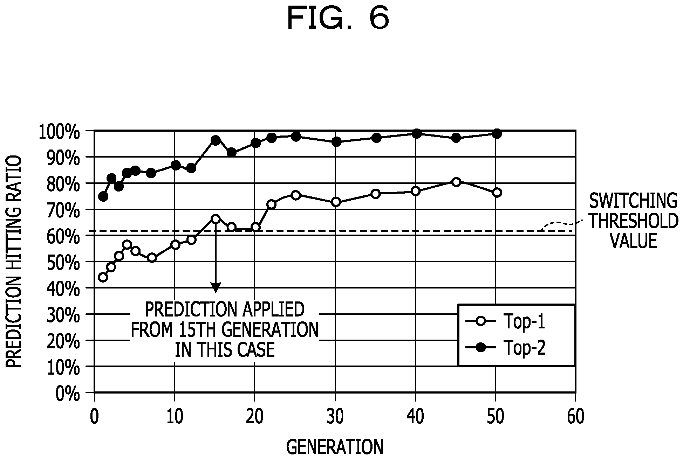

FIG. 6 illustrates an effect acquired when the hitting ratio evaluation according to Embodiment 1 is applied to optical SAW filter design. FIG. 6 illustrates an example of evolutionary computation in which there are 200 input values for one generation and 20000 input values of 100 generations are to be evaluated. The learning model 22 is a three-layered NN, and the solution candidate range is divided into 20 ranges. It is assumed that the threshold value is 60%.

The graph illustrated in FIG. 6 has an X axis indicating generation and a Y axis indicating prediction hitting ratio. Referring to the graph, the prediction hitting ratio are lower than the threshold value in the generations preceding to the 15th generation. The prediction hitting ratio are equal to or higher than the threshold value in the 15th generation and subsequent generations. In other words, for example, when the generation to be evaluated is the 15th generation, the hitting ratio evaluating unit 164 determines that the prediction hitting ratio calculated by using a plurality of input values of the 15th generation is equal to or higher than the threshold value (60%). The hitting ratio evaluating unit 164 decides to apply the prediction of eigen solution candidates in the 15th generation and subsequent generations.

Thus, when total 3000 data pieces (200 input values × 15 generations) from the first generation to the 15th generation are learned and the prediction of eigen solution candidates is applied in the subsequent 16 to 100 generations, the amount of computational complexity is 0.43 (13/30), compared with the case where the entire range search is performed on all of the 100 generations. For the calculation, it is assumed that the amount of computational complexity is 1 when the entire range search is performed on one generation and that the amount of computational complexity is 1/3 when the prediction of eigen solution candidates is applied. $1 \times 15/100 + 1/3 \times 85/100 = 13/30$

If total 5000 data pieces (200 input values × 25 generations) from the first generation to the 25th generation are learned and the prediction of eigen solution candidates is applied in the subsequent 26 to 100 generations, the amount of computational complexity is 0.5 (1/2), compared with the case where the entire range search is performed on all of the 100 generations. $1 \times 25/100 + 1/3 \times 75/100 = 1/2$

In other words, for example, the information processing apparatus 1 may reduce the amount of computational complexity of the evolutionary computation when the generation to which the prediction is to be applied is determined by using the prediction hitting ratio according to Embodiment 1. In other words, for example, the information processing apparatus 1 may suppress increases of the amount of computational complexity of repetitions for each generation due to prediction with low precision.

[Effects of Embodiment 1]

According to Embodiment 1, the information processing apparatus 1 repetitively calculates an objective function computed based on eigen solutions for input parameters to execute evolutionary computation that searches an optimum value of the input parameters. The information processing apparatus 1 predicts a plurality of eigen solution candidates for a plurality of input parameters of a first generation based on combinations of the plurality of input parameters of generations before the first generation and the plurality of eigen solutions calculated with a predetermined function from the plurality of input parameters. The information processing apparatus 1 calculates a plurality of eigen solutions for each of a plurality of input parameters of the first generation. The information processing apparatus 1 compares the calculated first plural eigen solutions for each of the plurality of input parameters of the first generation and the predicted first plural eigen solution candidates for each of the plurality of input parameters of the first generation to calculate the prediction hitting ratio. Based on the calculated prediction hitting ratio, the information processing apparatus 1 decides whether predicted second plural eigen solution candidates are decided as second plural eigen solutions without executing the step of calculating eigen solutions for calculating the second plural eigen solutions for the plurality of input parameters of the second generation that is a generation after the first generation. With this configuration, the information processing apparatus 1 may suppress increases of the amount of computational complexity for the repetitions for each generation to calculate eigen solutions due to the prediction with low precision by deciding whether the prediction of eigen solution candidates is to be executed by using the prediction hitting ratio for eigen solutions.

According to Embodiment 1, the information processing apparatus 1 decides the predicted second plural eigen solution candidates as the second plural eigen solutions when the prediction hitting ratio is equal to or higher than a threshold value. With this configuration, the information processing apparatus 1 may suppress increases of the amount of computational complexity for the repetitions for each generation to calculate eigen solutions because the step of calculating eigen solutions is not executed for the calculation of the second plural eigen solutions.

[Embodiment 2]

According to Embodiment 1, it has been described that the information processing apparatus 1 compares calculated precise eigen solutions and predicted eigen solution candidates for a plurality of input values of a generation to be evaluated, calculates a prediction hitting ratio, and decides whether the prediction of eigen solution candidates is to be executed or not based on the prediction hitting ratio. However, without limiting thereto, the information processing apparatus 1 may include a plurality of calculation techniques for calculating an eigen solution, monitor a prediction hitting ratio for each of the plurality of calculation techniques and select a calculation technique with the highest prediction hitting ratio. In other words, for example, the information processing apparatus 1 may monitor the number of calculations for each of a plurality of calculation techniques for calculating an eigen solution and select a calculation technique with the lowest number of calculations.

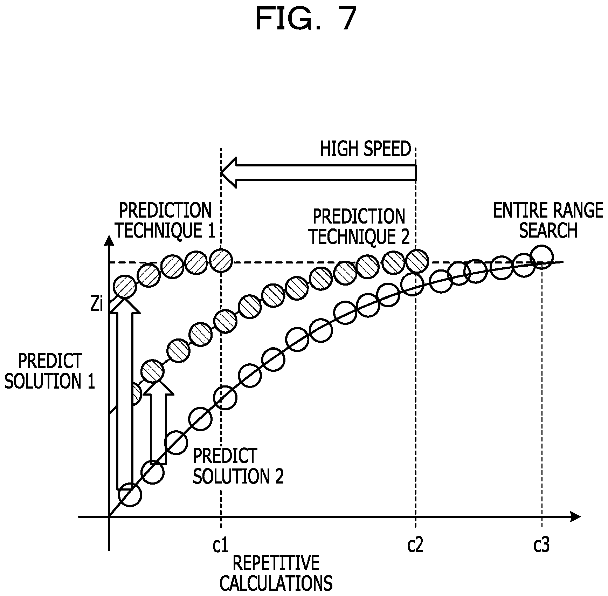

FIG. 7 is a diagram illustrating calculation techniques and the numbers of calculations. Hereinafter, each of the calculation techniques is written as a prediction technique. A prediction technique is a calculation technique that predicts an approximate eigen solution and searches in vicinity of the approximate eigen solution and is the partial range search. For example, a prediction technique 1 is a technique that predicts eigen solution candidates by using the learning model 22 that has trained by using input values of all generations before a generation to be evaluated, searches in vicinity (eigen solution range) of the eigen solution candidates and calculates a correct eigen solution. For example, a prediction technique 2 is a technique that predicts eigen solution candidates by using the learning model 22 that has trained by using input values of generations up to an initial specific generation before a generation to be evaluated, searches in vicinity (eigen solution range) of the eigen solution candidates and calculates a correct eigen solution. The prediction techniques 1 and 2 are illustrated for convenience, and the embodiment is not limited thereto.

As illustrated in FIG. 7, according to the prediction technique 1, the average of the numbers of calculations for acquiring a correct eigen solution is $c_1$ with respect to a plurality of input values of a generation to be evaluated. According to the prediction technique 2, the average of the numbers of calculations for acquiring a correct eigen solution is $c_2$ with respect to a plurality of input values of a generation to be evaluated. According to the calculation technique of the entire range search, the number of calculations for acquiring a correct eigen solution is $c_3$ with respect to a plurality of input values of a generation to be evaluated.

In this circumstance, the information processing apparatus 1 according to Embodiment 2 monitors the numbers of calculations of each calculation technique and selects the technique having the lowest number of calculations. The information processing apparatus 1 selects the prediction technique 1 having the lowest number of calculations. For the generations in and subsequent to the generation to be evaluated, the information processing apparatus 1 executes the prediction of eigen solution candidates by using the selected prediction technique 1 and searches a precise eigen solution from vicinity (eigen solution range) of the eigen solution candidates. Thus, the information processing apparatus 1 selects a prediction technique having the lowest number of calculations from the plurality of prediction techniques so that increases of the amount of computational complexity of the repetitions for each generation due to predictions with low precision may be suppressed.

Accordingly, according to Embodiment 2, a case will be described in which the information processing apparatus 1 monitors the numbers of calculations by a plurality of calculation techniques used for calculating an eigen solution and selects a calculation technique with the lowest number of calculations.

[Configuration of Information Processing Apparatus]

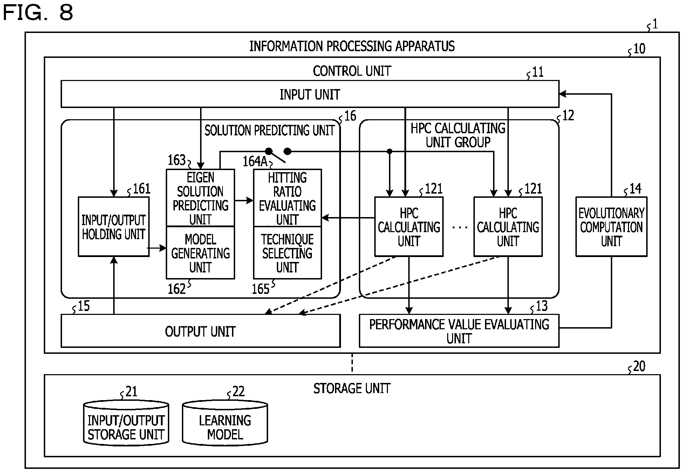

FIG. 8 is a functional block diagram illustrating a configuration of an information processing apparatus according to Embodiment 2. Elements of the information processing apparatus of FIG. 8 are designated with the same reference numerals as in the information processing apparatus 1 illustrated in FIG. 1, and the discussion of the identical elements and operation thereof is omitted herein. Embodiment 1 and Embodiment 2 are different in that the hitting ratio evaluating unit 164 is replaced by a hitting ratio evaluating unit 164A. Embodiment 1 and Embodiment 2 are different in that a technique selecting unit 165 is further provided.

The hitting ratio evaluating unit 164A evaluates a hitting ratio of an eigen solution prediction for each calculation technique.

For example, the hitting ratio evaluating unit 164A computes a prediction hitting ratio based on a calculation technique by using a plurality of input values.

The calculation techniques include, as an example, a calculation technique (m1) that searches for all of 1000 points when there are 1000 points of possible ranges of an eigen solution. The calculation techniques include, as another example, a calculation technique (m2) that searches for all of 1000 points but, when an eigen solution is found, aborts halfway through the search. The calculation techniques include prediction techniques. An example of the prediction techniques is a technique (m3) that predicts eigen solution candidates by using the learning model 22 that has trained by using input values of all generations before a generation to be evaluated, searches in vicinity (eigen solution range) of the eigen solution candidates and calculates a correct eigen solution. Another example of the prediction techniques is a technique (m4) that predicts eigen solution candidates by using the learning model 22 that has trained by using input values of generations up to an initial specific generation before a generation to be evaluated, searches in vicinity (eigen solution range) of the eigen solution candidates and calculates a correct eigen solution. Another example of the prediction techniques is a technique (m5) that predicts eigen solution candidates by using the learning model 22 that has trained by using input values of a plurality of immediately close generations before a generation to be evaluated, searches in vicinity (eigen solution range) of the eigen solution candidates and calculates a correct eigen solution.

According to the prediction techniques of the calculation techniques, the expression "precise eigen solution" here refers to an eigen solution found by partial range search or, when an eigen solution is not found by the partial range search, an eigen solution found by entire range search through the solution candidate range predicted by the learning model 22. In other words, for example, the hitting ratio evaluating unit 164A compares a predicted solution candidate range and a precise eigen solution for one input value and evaluates as that the prediction is right if the precise eigen solution is found by the partial range search of the solution candidate range. The hitting ratio evaluating unit 164A compares the predicted solution candidate range and a precise input value for one input value. If the precise eigen solution is not found by the partial range search through the solution candidate range, the hitting ratio evaluating unit 164 evaluates as that the prediction is not right.

For each of the calculation techniques, the hitting ratio evaluating unit 164A determines whether the prediction hitting ratio are equal to or higher than a threshold value or not for the plurality of input values of the generation to be evaluated. The threshold value is 60%, for example, but the embodiment is not limited thereto. If the prediction hitting ratio of any one of the plurality of prediction techniques is equal to or higher than the threshold value, the hitting ratio evaluating unit 164A decides to apply the prediction with the eigen solution candidates. If the prediction hitting ratio of all of the plurality of prediction techniques are lower than the threshold value, the hitting ratio evaluating unit 164A decides not to apply the prediction with the eigen solution candidates.

The technique selecting unit 165 selects the prediction technique to be executed among the plurality of prediction techniques based on the prediction hitting ratio of each of the plurality of prediction techniques. For example, if it is decided to apply the prediction, the technique selecting unit 165 selects a prediction technique with the highest prediction hitting ratio among the plurality of prediction techniques. By using the selected prediction technique, the technique selecting unit 165 decides to execute the prediction by using the selected prediction technique for a plurality of input values of a generation in and subsequent to the generation to be evaluated. The technique selecting unit 165 updates the selected prediction technique as a prediction technique to be executed next.

[Example of Case Using Hitting Ratio Evaluation]

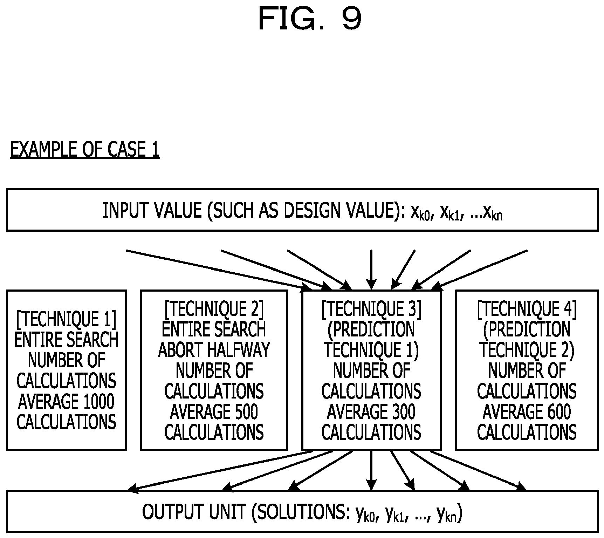

FIG. 9 illustrates an example of a case applying the hitting ratio evaluation according to Embodiment 2. FIG. 9 illustrates a case where, when there are four calculation techniques for calculating an eigen solution, for example, a calculation technique with the lowest number of calculations is to be selected. Because the number of calculations for acquiring an eigen solution is low when the prediction hitting ratio is high, the number of calculations is applied instead of the prediction hitting ratio in FIG. 9.

The four calculation techniques are as follows. A calculation technique 1 is a technique (m1) with the entire range search, and the technique searches for all of 1000 points when there are 1000 points of possible ranges of an eigen solution. A calculation technique 2 is a technique (m2) with the entire range search, but the technique aborts halfway when an eigen solution is found. A calculation technique 3 is a prediction technique (m3) that predicts eigen solution candidates by using the learning model 22 that has trained by using input values of all generations before a generation to be evaluated, searches in vicinity (eigen solution range) of the eigen solution candidates and calculates a correct eigen solution. A calculation technique 4 is a prediction technique (m4) that predicts eigen solution candidates by using the learning model 22 that has trained by using input values of generations up to an initial specific generation before a generation to be evaluated, searches in vicinity (eigen solution range) of the eigen solution candidates and calculates a correct eigen solution. Having described that there are four calculation techniques, the embodiment is not limited thereto. There may be two, three or five techniques. The calculation technique 1 to 4 are illustrated for convenience, and the embodiment is not limited thereto.

For example, a case is assumed in which there are 100 input values of a generation to be evaluated. The eigen solution predicting unit 163 calculates a solution candidate range and a precise eigen solution by each of the calculation techniques with respect to the plurality of input values of the generation to be evaluated. All of 100 input values may be used first for each of the calculation techniques, but the 100 input values may be divided proportionately and 25 input values may be used for each of the calculation techniques.

The hitting ratio evaluating unit 164A computes a prediction hitting ratio for each of the calculation techniques. An average number of calculations is computed instead of a prediction hitting ratio. With the calculation technique 1, the average number of calculations is 1000. With the calculation technique 2, the average number of calculations is 500. With the calculation technique 3, the average number of calculations is 300. With the calculation technique 4, the average number of calculations is 600.

The technique selecting unit 165 selects a calculation technique with a highest prediction hitting ratio among a plurality of calculation techniques based on prediction hitting ratio of the plurality of calculation techniques. Because an average number of calculations is computed instead of a prediction hitting ratio, a calculation technique with a lowest average number of calculations is selected among a plurality of calculation techniques. In other words, for example, the calculation technique 3 is selected.

For the generations in and subsequent to the generation to be evaluated, the eigen solution predicting unit 163 executes the prediction of eigen solution candidates by using the selected calculation technique 3 and searches a precise eigen solution from vicinity of the eigen solution candidates. The generation to be evaluated may be provided every 10 generations or may be provided every one generation.

[Another Example of Case Using Hitting Ratio Evaluation]

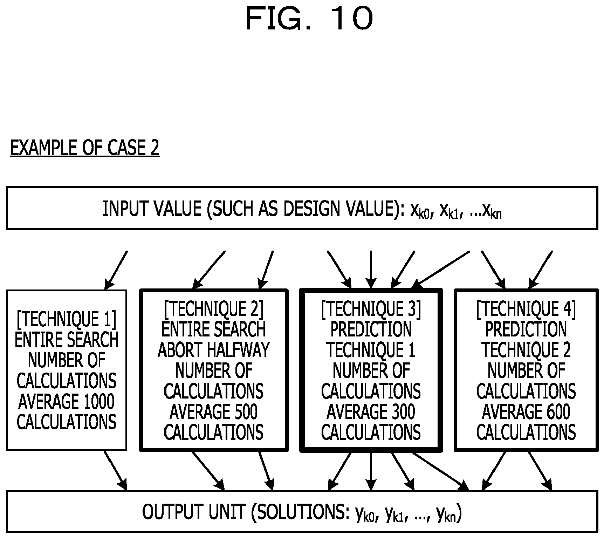

FIG. 10 illustrates another example of a case applying the hitting ratio evaluation according to Embodiment 2. FIG. 10 illustrates a case where, when there are four calculation techniques for calculating an eigen solution, the proportion of the calculation techniques with lower numbers of calculations is set at higher levels, and the calculation techniques with higher number of calculations is set at lower level. In this case, the numbers of calculations of the calculation techniques are monitored for each generation, and the set proportions are updated at all times. Because the average of the number of calculations for calculating an eigen solution is low when a prediction hitting ratio is high, the number of calculations is applied instead of a prediction hitting ratio in FIG. 10.

The four calculation techniques are the same as the calculation techniques described in the case 1 in FIG. 9, for example. Having described that there are four calculation techniques, the embodiment is not limited thereto. There may be two, three or five techniques. The calculation technique 1 to 4 are illustrated for convenience, and the embodiment is not limited thereto.

For example, a case is assumed in which there are 100 input values of a generation to be evaluated. The eigen solution predicting unit 163 calculates a solution candidate range and a precise eigen solution by each of the calculation techniques with respect to the plurality of input values of the generation to be evaluated. As an example, 100 input values may be used first for each of the calculation techniques, but the 100 input values may be divided proportionately and 25 input values may be used for each of the calculation techniques.

The hitting ratio evaluating unit 164A computes a prediction hitting ratio for each of the calculation techniques. An average number of calculations is computed instead of a prediction hitting ratio, like the case 1 in FIG. 9. With the calculation technique 1, the average number of calculations is 1000. With the calculation technique 2, the average number of calculations is 500. With the calculation technique 3, the average number of calculations is 300. With the calculation technique 4, the average number of calculations is 600.

The technique selecting unit 165 sets the proportions of the calculation techniques based on prediction hitting ratio of the plurality of calculation techniques. Because an average number of calculations is computed instead of a prediction hitting ratio, the proportion of the calculation technique 3 with the lowest average number of calculations is set at the highest level, and the proportions of the calculation techniques 2 and 4 with the next lower average numbers of calculations are set at a next higher level. The proportion of the calculation technique 1 with the highest average number of calculations is set at the lowest level.

The eigen solution predicting unit 163 allocates a plurality of input values of a generation next to the generation to be evaluated to the plurality of calculation techniques based on the set proportions. The eigen solution predicting unit 163 executes the calculation techniques by using the input values allocated to the plurality of calculation techniques and calculates a solution candidate range and a precise eigen solution by each of the calculation techniques. The generation to be evaluated may be provided every one generation or may be provided every plurality of generations.

[Flowchart for Technique Selecting Unit]

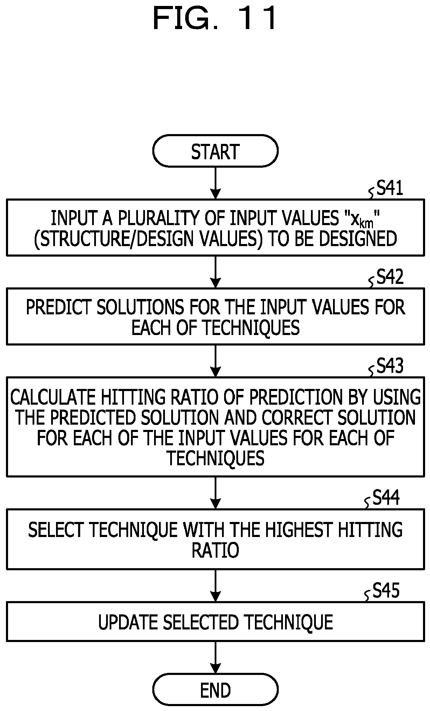

FIG. 11 illustrates an example of a flowchart for the technique selection according to Embodiment 2. A generation k is to be evaluated for a hitting ratio.

As illustrated in FIG. 11, the eigen solution predicting unit 163 inputs a plurality of input values "$x_{km}$" to be designed (structures/design values) (step S41).

The eigen solution predicting unit 163 predicts an eigen solution for an input value for each of the calculation techniques (step S42). For example, the eigen solution predicting unit 163 allocates a plurality of input values to the plurality of calculation techniques. When the calculation technique is a prediction technique, the eigen solution predicting unit 163 estimates a solution candidate range of an eigen solution for the input values by using the learning model 22 corresponding to the prediction technique with respect to the allocated input values. When $A_1 = 1$ and $B_1 = 0$ of the eigen solution condition in Expression (2) are input, the eigen solution predicting unit 163 calculates the function h(z) for acquiring $A_n$ for the allocated input values. The eigen solution predicting unit 163 solves the equation resulting in $A_n$ or h(z) equal to zero with respect to points of z in the estimated solution candidate range because of the condition of $A_n = 0$ of the eigen solution condition in Expression (2) for the allocated input values to acquire an eigen solution. If the eigen solution prediction fails, the eigen solution predicting unit 163 outputs the input value to the HPC calculating unit 121 and causes the HPC calculating unit 121 to acquire a precise eigen solution by the entire range search. When the calculation technique is not a prediction technique, the eigen solution predicting unit 163 outputs the allocated input values to the HPC calculating unit 121 and causes the HPC calculating unit 121 to acquire a precise eigen solution by the entire range search.

Next, the hitting ratio evaluating unit 164A calculates a prediction hitting ratio by using an eigen solution predicted for the input values and a precise eigen solution for each of the calculation techniques (step S43). For example, the hitting ratio evaluating unit 164A compares a predicted solution candidate range and a precise eigen solution for one input value for a certain calculation technique and evaluates as that the prediction is right if the precise eigen solution is found in the solution candidate range. The hitting ratio evaluating unit 164A compares the predicted solution candidate range and a precise input value for one input value for a certain calculation technique. If the precise eigen solution is not found in the solution candidate range, the hitting ratio evaluating unit 164A evaluates as that the prediction is not right. The hitting ratio evaluating unit 164A calculates a prediction hitting ratio based on the evaluation for the plurality of input values allocated to a certain calculation technique. The hitting ratio evaluating unit 164A may calculate an average number of calculations instead of a prediction hitting ratio for each of the calculation techniques.

The technique selecting unit 165 selects a calculation technique with the highest prediction hitting ratio (step S44). The technique selecting unit 165 updates the selected calculation technique as a calculation technique to be executed next (step S45). After that, for the generations in and subsequent to the generation to be evaluated, the eigen solution predicting unit 163 executes the prediction of eigen solution candidates by using the selected calculation technique and searches a precise eigen solution from vicinity of the eigen solution candidates.

When the hitting ratio evaluating unit 164A calculates average numbers of calculations instead of prediction hitting ratio, the technique selecting unit 165 may select a calculation technique as follows. The technique selecting unit 165 decides the proportions of the calculation techniques based on the average numbers of calculations of the plurality of calculation techniques. The technique selecting unit 165 sets the proportion of the calculation technique with the lowest average number of calculations to the highest level and sets the proportion of the calculation technique with the highest average number of calculations to the lowest level. After that, the eigen solution predicting unit 163 allocates a plurality of input values of the generation next to the generation to be evaluated to the calculation techniques based on the set proportions, executes the calculation techniques by using the allocated input values and calculates a solution candidate range and a precise eigen solution for each of the calculation techniques.

[Effects of Embodiment 2]

According to Embodiment 2 described above, the information processing apparatus 1 predicts eigen solution candidates based on combinations of a plurality of input parameters and the calculated eigen solutions by using different generation groups for each plurality of prediction techniques for generations before the first generation. The information processing apparatus 1 computes a prediction hitting ratio for each of the plurality of prediction techniques. The information processing apparatus 1 decides whether prediction by one of the plurality of prediction techniques is to be executed or not based on the prediction hitting ratio of each of the plurality of prediction techniques. With the configuration, the information processing apparatus 1 may decide an optimum prediction technique to be executed based on the prediction hitting ratio of each of the plurality of prediction techniques. As a result, the information processing apparatus 1 may suppress increases of the amount of computational complexity of repetitions for each generation due to prediction with low precision.

According to Embodiment 2 described above, the information processing apparatus 1 decides to execute the prediction of eigen solution candidates by the prediction technique with the highest prediction hitting ratio among a plurality of prediction techniques with respect to a plurality of input parameters of a generation after the first generation. With the configuration, for the generation after the first generation, the information processing apparatus 1 may suppress increases of the amount of computational complexity of the repetitions for calculating an eigen solution for the input parameters.

According to Embodiment 2 described above, the information processing apparatus 1 decides proportions of a plurality of prediction techniques based on prediction hitting ratio of the prediction techniques. The information processing apparatus 1 allocates the plurality of input parameters of the generation after the first generation to the prediction techniques based on the decided proportions. The information processing apparatus 1 decides to execute the prediction techniques by using the allocated input parameters. With the configuration, the information processing apparatus 1 may suppress increases of the amount of computational complexity of the repetitions of eigen solution calculations for the input parameters of a generation after the first generation.

According to Embodiment 2 described above, the information processing apparatus 1 updates the prediction technique decided to be executed for each first generation to be evaluated. With the configuration, the information processing apparatus 1 updates the prediction technique to be executed for each generation to be evaluated so that a proper prediction technique may be executed in evolutionary computation that shifts in a process of evolutions of input parameters and that the amount of computational complexity of the evolutionary computation may be reduced.

[Another Example Using Eigen Solution Prediction]

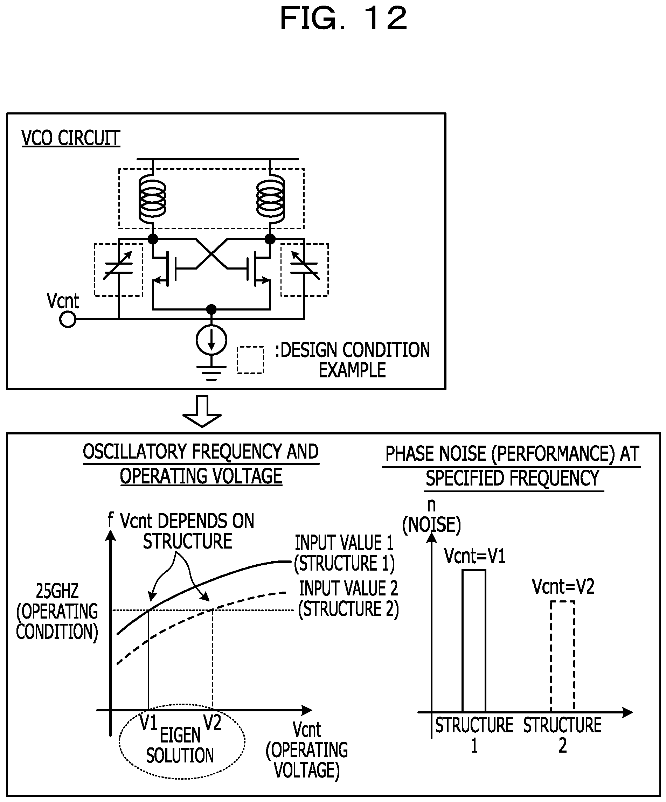

A case has been described in which an optical SAW filter is designed with the eigen solution prediction according to Embodiments 1 and 2. Another example using the eigen solution prediction according to Embodiments 1 and 2 will be described with reference to FIG. 12. FIG. 12 illustrates another example using the eigen solution prediction according to Embodiments 1 and 2. With reference to FIG. 12, a case will be described in which a design of a voltage control oscillator (VCO) is acquired by evolutionary computation.

The upper drawing of FIG. 12 illustrates a VCO circuit. Examples of design conditions are enclosed by broken lines.

The lower left diagram of FIG. 12 illustrates a relationship between oscillatory frequency and operating voltage. The VCO circuit is used by setting the operating voltage such that the oscillatory frequency operates at a specified value (such as 25.0 GHz) as a target value. In this case, 25.0 GHz is a specified value as an oscillatory frequency f. In a structure represented by an input value 1, when the VCO circuit operates with the specified value, the operating voltage indicates V1. In a structure represented by an input value 2, when the VCO circuit operates with the specified value, the operating voltage indicates V2. In this way, the operating voltage depends on the structure.

The lower right diagram of FIG. 12 illustrates phase noise at specified frequencies. The VCO circuit is not only to have an oscillatory frequency operating at a specified value but also to have small phase noise in a condition according to the specifications. In this case, the structure 2 represented by the input value 2 has lower phase noise than that of the structure 1 represented by the input value 1. This means that the structure 2 is a more optimum structure than the structure 1.

Under this design summary of the VCO circuit, input values (design conditions regarding a structure and parameter values) for an inductor and a variable capacitance are adjusted in the design process to search an optimum structure. However, when the input values are changed, the operating voltage for the input values changes. Therefore, the operating voltage (Vcnt) having the specified oscillatory frequency f is predicted every time in accordance with the input values, and the phase noise is to be evaluated under conditions depending on the specifications.

Accordingly, for example, design conditions of the structure and parameters of the VCO circuit are associated with the "input value" according to Embodiment 1. The operating voltage under the specification condition for the input value is associated with the "eigen solution". The phase noise under the condition based on the specifications for the input value is associated with the evaluation value. For example, a VCO may be designed by using the hitting ratio evaluation and the eigen solution prediction according to Embodiment 1 as follows.

The HPC calculating unit 121 receives an input value regarding a design condition of a predetermined generation and searches an operating voltage satisfying the specification condition for the input value through the possible entire range of the operating voltage.

Based on the operating voltage for the input value, which is searched by the entire range search, the model generating unit 162 generates the learning model 22 that predicts the range in which the operating voltage satisfying the specification condition for the input value exists.

The eigen solution predicting unit 163 uses the learning model 22 to predict the range (solution candidate range) in which the operating voltage for the input values exists. The eigen solution predicting unit 163 predicts the operating voltage for the input value, which satisfies the specification condition for the input value, within the predicted operating voltage range. If the prediction of the operating voltage fails, the eigen solution predicting unit 163 may cause the HPC calculating unit 121 to search the operating voltage for the input value by performing the entire range search.

The hitting ratio evaluating unit 164 compares solution candidate ranges predicted by using the learning model 22 and precise operating voltages with respect to a plurality of input values in the generation to be evaluated and calculates prediction hitting ratio thereof. The hitting ratio evaluating unit 164 determines whether the prediction hitting ratio is equal to or higher than a threshold value or not for the plurality of input values of the generation to be evaluated. If the prediction hitting ratio is equal to or higher than the threshold value, the hitting ratio evaluating unit 164 decides to apply the prediction with the solution candidate range. If the prediction hitting ratio is lower than the threshold value, the hitting ratio evaluating unit 164 decides not to apply the prediction with the solution candidate range.

Thus, the information processing apparatus 1 may suppress increases of the amount of computational complexity for the repetitions for each generation to calculate an operating voltage due to the prediction with low precision by deciding whether the prediction with a solution candidate range for an operating voltage is to be executed or not based on the prediction hitting ratio of the operating voltages.

[Others]

The components of the information processing apparatus 1 illustrated in the drawings do not necessarily have to be physically configured as illustrated in the drawings. In other words, for example, the specific forms of distribution and integration of the information processing apparatus 1 are not limited to those illustrated in the drawings, and all or part thereof may be configured to be functionally or physically distributed or integrated in given units in accordance with various loads, usage states, and so on. For example, the output unit 15 and the input/output holding unit 161 may be integrated as one unit. The HPC calculating unit 121 may be divided into a calculating unit that searches an eigen solution by entire range search, a unit that calculates an objective function based on the eigen solution and a unit that calculates a performance value for an input value based on the objective function. The storage unit 20 may be coupled via a network as an external device of the information processing apparatus 1.

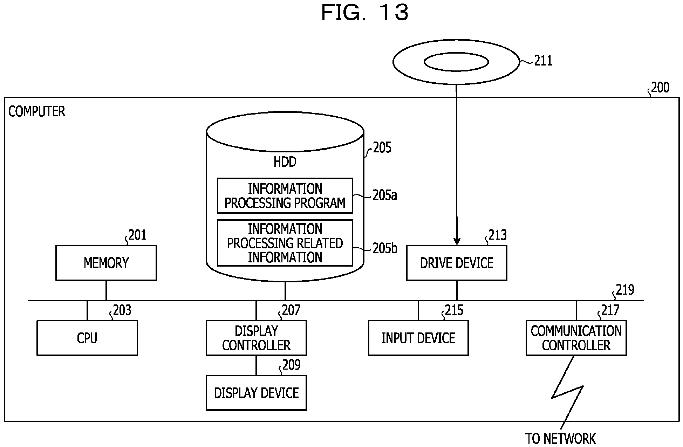

The various processes described in the embodiment above may be implemented as a result of a computer such as a personal computer or a workstation executing a program prepared in advance. Hereinafter, an example of the computer that executes the information processing program implementing functions that are the same as those of the information processing apparatus 1 illustrated in FIG. 1 will be described. FIG. 13 illustrates an example of a computer that executes an information processing program.

As illustrated in FIG. 13, a computer 200 includes a CPU 203 that performs various kinds of arithmetic processing, an input device 215 that receives input of data from a user, and a display controller 207 that controls a display device 209. The computer 200 further includes a drive device 213 that reads a program or the like from a storage medium, and a communication controller 217 that exchanges data with another computer via a network. The computer 200 further includes a memory 201 that temporarily stores various kinds of information, and a hard disk drive (HDD) 205. The memory 201, the CPU 203, the HDD 205, the display controller 207, the drive device 213, the input device 215, and the communication controller 217 are coupled to one another via a bus 219.

The drive device 213 is, for example, a device for a removable disk 210. The HDD 205 stores an information processing program 205a and information processing related information 205b.

The CPU 203 reads the information processing program 205a, develops the information processing program 205a in the memory 201, and executes the information processing program 205a as processes. Such processes correspond to the respective functional units of the information processing apparatus 1. The information processing related information 205b corresponds to the input/output storage unit 21 and the learning model 22. For example, the removable disk 210 stores various information of the information processing program 205a or the like.

The information processing program 205a may not necessarily have to be stored in the HDD 205 from the beginning. For example, the information processing program 205a may be stored in a "portable physical medium" such as a flexible disk (FD), a compact disk read-only memory (CD-ROM), a digital versatile disk (DVD), a magneto-optical disk, or an integrated circuit (IC) card inserted into the computer 200. The computer 200 may execute the information processing program 205a by reading the information processing program 205a from the portable physical medium.

All examples and conditional language provided herein are intended for the pedagogical purposes of aiding the reader in understanding the invention and the concepts contributed by the inventor to further the art, and are not to be construed as limitations to such specifically recited examples and conditions, nor does the organization of such examples in the specification relate to a showing of the superiority and inferiority of the invention. Although one or more embodiments of the present invention have been described in detail, it should be understood that the various changes, substitutions, and alterations could be made hereto without departing from the spirit and scope of the invention.

[CITATION LIST]

[PATENT LITERATURE]

Examples of the related art include Japanese Laid-open Patent Publication Nos. 2002-230514 and 2002-245434.

[NON PATENT LITERATURE]

Examples of the related art further include Yukito Tsunoda et al.: "Neural-network assistance to calculate precise eigenvalue for fitness evaluation of real product design". GECCO2019, p. 405-406.

[REFERENCE SIGNS LIST]

1 information processing apparatus
10 control unit
11 input unit
12 HPC calculating unit group
13 performance value evaluating unit
14 evolutionary computation unit
15 output unit
16 solution predicting unit
161 input/output holding unit
162 model generating unit
163 eigen solution predicting unit
164, 164A hitting ratio evaluating unit
165 technique selecting unit
20 storage unit
21 input/output storage unit
22 learning model

**Claims**

1. An information processing apparatus comprising:

   a memory configured to store program instructions; and
   a processor configured to execute the program instruction for an evolutionary computation that searches an optimum value of the input parameters, the evolutionary computation being configured to repetitively calculate an objective function computed based on eigen solutions for input parameters,
the program instructions including:

executing a prediction processing configured to predict a plurality of eigen solution candidates for a plurality of input parameters of a first generation based on combinations of the plurality of input parameters of the generation before the first generation and the plurality of eigen solutions calculated with a predetermined function from the plurality of input parameters;

executing a first calculation processing configured to calculate a plurality of eigen solutions for each of a plurality of input parameters of the first generation;

executing a second calculation processing configured to calculate a prediction hitting ratio by comparing calculated first plural eigen solutions for each of the plurality of input parameters of the first generation and predicted first plural eigen solution candidates for each of the plurality of input parameters of the first generation; and

executing a decision processing configured to decide, based on the calculated prediction hitting ratio, whether predicted second plural eigen solution candidates are decided as second plural eigen solutions without executing the first calculation processing of calculating the eigen solutions for calculating the second plural eigen solutions for the plurality of input parameters of the second generation that is a generation after the first generation.

2. The information processing apparatus according to claim 1,
wherein the decision processing is configured to decide the predicted second plural eigen solution candidates as the second plural eigen solutions when the prediction hitting ratio calculated by the second calculation processing is equal to or higher than a threshold value.

3. The information processing apparatus according to claim 1 or claim 2,
wherein the prediction processing is configured to predict a plurality of eigen solution candidates based on combinations of a plurality of parameters and a plurality of eigen solutions calculated with a predetermined function from the plurality of input parameters by using generation groups that differ in accordance with a plurality of prediction techniques for a generation before the first generation,
wherein the second calculation processing is configured to calculate the prediction hitting ratio for each of the plurality of prediction techniques, and
wherein the decision processing is configured to decide whether prediction by one prediction technique of the plurality of prediction techniques is to be executed or not based on the prediction hitting ratio of each of the plurality of prediction techniques.

4. The information processing apparatus according to claim 3,
wherein the decision processing is configured to decide to execute the prediction by the prediction technique with the highest prediction hitting ratio among the plurality of prediction techniques for a plurality of input parameters of a generation after the first generation.

5. The information processing apparatus according to claim 3,
wherein the decision processing is configured to
decide a proportion of each of the prediction techniques based on the prediction hitting ratio of each of the plurality of prediction techniques,
allocate a plurality of input parameters of a generation after the first generation to the prediction techniques based on the decided proportions, and
execute each of the prediction techniques by using the allocated input parameters.

6. The information processing apparatus according to claim 4,
wherein the first generation represents a generation to be evaluated, and
wherein the decision processing is configured to update the prediction technique decided to execute for the generation to be evaluated.

7. An information processing program which causes a processor to perform processing, the processing comprising:

in evolutionary computation that searches an optimum value of input parameters by repetitively calculating an objective function computed based on eigen solutions for the input parameters,
executing a prediction processing configured to predict a plurality of eigen solution candidates for a plurality of input parameters of a first generation based on combinations of the plurality of input parameters of the generation before the first generation and the plurality of eigen solutions calculated with a predetermined function from the plurality of input parameters;

executing a first calculation processing configured to calculate a plurality of eigen solutions for each of a plurality of input parameters of the first generation;

executing a second calculation processing configured to calculate a prediction hitting ratio by comparing calculated first plural eigen solutions for each of the plurality of input parameters of the first generation and predicted first plural eigen solution candidates for each of the plurality of input parameters of the first generation; and

executing a decision processing configured to decide, based on the calculated prediction hitting ratio, whether predicted second plural eigen solution candidates are decided as second plural eigen solutions without executing the first calculation processing of calculating the eigen solutions for calculating the second plural eigen solutions for the plurality of input parameters of the second generation that is a generation after the first generation.

8. An information processing method implemented by a computer, the information processing method comprising:

in evolutionary computation that searches an optimum value of input parameters by repetitively calculating an objective function computed based on eigen solutions for the input parameters,

executing a prediction processing configured to predict a plurality of eigen solution candidates for a plurality of input parameters of a first generation based on combinations of the plurality of input parameters of the generation before the first generation and the plurality of eigen solutions calculated with a predetermined function from the plurality of input parameters;

executing a first calculation processing configured to calculate a plurality of eigen solutions for each of a plurality of input parameters of the first generation;

executing a second calculation processing configured to calculate a prediction hitting ratio by comparing calculated first plural eigen solutions for each of the plurality of input parameters of the first generation and predicted first plural eigen solution candidates for each of the plurality of input parameters of the first generation; and

executing a decision processing configured to decide, based on the calculated prediction hitting ratio, whether predicted second plural eigen solution candidates are decided as second plural eigen solutions without executing the first calculation processing of calculating the eigen solutions for calculating the second plural eigen solutions for the plurality of input parameters of the second generation that is a generation after the first generation.

FIG. 1

# FIG. 2

INPUT
VALUE $x_{km}$

ESTIMATED
$g(x_{km})$

## FIG. 3

# FIG. 4

START
(GENERATION k TO BE EVALUATED)

INPUT A PLURALITY OF INPUT VALUES "$x_{km}$" (STRUCTURE/DESIGN VALUES) TO BE DESIGNED — S11

PREDICT SOLUTIONS FOR THE INPUT VALUES — S12

CALCULATE HITTING RATIO OF PREDICTION BY USING THE PREDICTED SOLUTION AND PRECISE SOLUTION FOR EACH OF THE INPUT VALUES — S13

S14
IS HITTING RATIO EQUAL TO OR HIGHER THAN THRESHOLD VALUE? — NO

YES — S15
APPLY THE PREDICTION

S16
DO NOT APPLY THE PREDICTION

END

# FIG. 5

START

INPUT A PLURALITY OF INPUT VALUES "$x_{km}$" (STRUCTURE/DESIGN VALUES) TO BE DESIGNED ⟿ S21

IS PREDICTION APPLIED TO GENERATION k OR GENERATION k IS TO BE EVALUATED? ⟋ S22 — NO

YES

PREDICT CANDIDATE RANGE OF SOLUTION FOR EQUATION ⟿ S23

COMPUTE PRECISE SOLUTION BY CALCULATING VICINITY OF PREDICTION ⟿ S24

COMPUTED? ⟋ S24A — NO

YES

COMPUTE PRECISE SOLUTION BY CALCULATING THE ENTIRE RANGE ⟋ S25

CALCULATE PERFORMANCE OF EACH INPUT VALUE ⟿ S26

EVALUATE EACH INPUT VALUE TO PERFORMANCE ⟿ S27

SATISFY END CONDITION? ⟋ S28 — NO

YES ⟋ S31

SELECT OPTIMUM INPUT VALUE

END

SELECT FROM INPUT VALUES "$x_{km}$" ⟋ S29

GENERATE INPUT VALUES "$x_{k+1m}$" OF NEXT GENERATION (CROSSING AND VARIATIONS) ⟋ S30

25

# FIG. 6

# FIG. 7

FIG. 8

INFORMATION PROCESSING APPARATUS ⸘1

CONTROL UNIT ⸘10

INPUT UNIT ⸘11

SOLUTION PREDICTING UNIT ⸘16

HPC CALCULATING UNIT GROUP ⸘12

163 ⸘

164A ⸘

EIGEN SOLUTION PREDICTING UNIT

HITTING RATIO EVALUATING UNIT

⸘121

⸘121

⸘14

INPUT/OUTPUT HOLDING UNIT ⸘161

MODEL GENERATING UNIT

TECHNIQUE SELECTING UNIT

HPC CALCULATING UNIT

· · ·

HPC CALCULATING UNIT

EVOLUTIONARY COMPUTATION UNIT

162 ⸘

165 ⸘

⸘15

OUTPUT UNIT

⸘13

PERFORMANCE VALUE EVALUATING UNIT

STORAGE UNIT ⸘20

⸘21

⸘22

INPUT/OUTPUT STORAGE UNIT

LEARNING MODEL

# FIG. 9

EXAMPLE OF CASE 1

| INPUT VALUE (SUCH AS DESIGN VALUE): $x_{k0}, x_{k1}, ...x_{kn}$ |
|---|

| [TECHNIQUE 1] ENTIRE SEARCH NUMBER OF CALCULATIONS AVERAGE 1000 CALCULATIONS | [TECHNIQUE 2] ENTIRE SEARCH ABORT HALFWAY NUMBER OF CALCULATIONS AVERAGE 500 CALCULATIONS | [TECHNIQUE 3] (PREDICTION TECHNIQUE 1) NUMBER OF CALCULATIONS AVERAGE 300 CALCULATIONS | [TECHNIQUE 4] (PREDICTION TECHNIQUE 2) NUMBER OF CALCULATIONS AVERAGE 600 CALCULATIONS |

| OUTPUT UNIT (SOLUTIONS: $y_{k0}, y_{k1}, ..., y_{kn}$) |
|---|

# FIG. 10

EXAMPLE OF CASE 2

| INPUT VALUE (SUCH AS DESIGN VALUE): $x_{k0}, x_{k1}, ...x_{kn}$ |
|---|

| [TECHNIQUE 1] ENTIRE SEARCH NUMBER OF CALCULATIONS AVERAGE 1000 CALCULATIONS | [TECHNIQUE 2] ENTIRE SEARCH ABORT HALFWAY NUMBER OF CALCULATIONS AVERAGE 500 CALCULATIONS | [TECHNIQUE 3] PREDICTION TECHNIQUE 1 NUMBER OF CALCULATIONS AVERAGE 300 CALCULATIONS | [TECHNIQUE 4] PREDICTION TECHNIQUE 2 NUMBER OF CALCULATIONS AVERAGE 600 CALCULATIONS |
|---|---|---|---|

| OUTPUT UNIT (SOLUTIONS: $y_{k0}, y_{k1}, ..., y_{kn}$) |
|---|

# FIG. 11

START

$\downarrow$ S41

INPUT A PLURALITY OF INPUT VALUES "$x_{km}$" (STRUCTURE/DESIGN VALUES) TO BE DESIGNED

$\downarrow$ S42

PREDICT SOLUTIONS FOR THE INPUT VALUES FOR EACH OF TECHNIQUES

$\downarrow$ S43

CALCULATE HITTING RATIO OF PREDICTION BY USING THE PREDICTED SOLUTION AND CORRECT SOLUTION FOR EACH OF THE INPUT VALUES FOR EACH OF TECHNIQUES

$\downarrow$ S44

SELECT TECHNIQUE WITH THE HIGHEST HITTING RATIO

$\downarrow$ S45

UPDATE SELECTED TECHNIQUE

$\downarrow$

END

# FIG. 12

**VCO CIRCUIT**

Vcnt

⬜ :DESIGN CONDITION EXAMPLE

⬇

**OSCILLATORY FREQUENCY AND OPERATING VOLTAGE**

f Vcnt DEPENDS ON STRUCTURE

INPUT VALUE 1 (STRUCTURE 1)

INPUT VALUE 2 (STRUCTURE 2)

25GHZ (OPERATING CONDITION)

V1 EIGEN V2 SOLUTION

Vcnt (OPERATING VOLTAGE)

**PHASE NOISE (PERFORMANCE) AT SPECIFIED FREQUENCY**

n (NOISE)

Vcnt=V1

Vcnt=V2

STRUCTURE 1      STRUCTURE 2

# FIG. 13

# FIG. 14

(a) Conventional SAW guide

(b) Divided type SAW guide

# FIG. 15

N_eff EIGEN SOLUTION

EXCLUDING N_eff EIGEN SOLUTION

# FIG. 16

ENTIRE SEARCH FOR 1000 POINTS

POSSIBLE RANGE OF EIGEN SOLUTION

$A_{Lk}$

EIGEN SOLUTION $g(x_k)$

0     z

EIGEN INTENSITY DISTRIBUTION CALCULATED BASED ON EIGEN SOLUTIONS

$A_L$

$f(x_k)$

COMPUTE VALUE HERE AS PERFORMANCE VALUE

0     POSITION

PERFORMANCE

$f(x)$

1.4
1.2
1.0
0.8

PERFORMANCE EVALUATION

$x_1$: △
$x_2$: ○
$x_3$: ◎
$x_4$: ×

0   $x_1$   $x_2$   $x_3$   $x_4$    INPUT VALUE x

---

START

INPUT A PLURALITY OF INPUT VALUES "$x_{km}$" (STRUCTURE/DESIGN VALUES) TO BE DESIGNED   ⌐S110

CALCULATE OPERATING CONDITION INHERENT TO EACH INPUT VALUE (SEARCH EIGEN SOLUTION AND EIGEN ACTION FROM ENTIRE RANGE)   ⌐S120

DECIDE EIGEN SOLUTION AND EIGEN ACTION   ⌐S130

COMPUTE PERFORMANCE OF TARGET INPUT VALUE   ⌐S140

EVALUATE EACH INPUT VALUE TO PERFORMANCE   ⌐S150

END CONDITION : "NO"

END CONDITION : "YES"

SELECT OPTIMUM INPUT VALUE   ⌐S180

END

---

k: GENERATION NUMBERS 1 TO j
m: INPUT VALUE NUMBERS 1 TO n WITHIN GENERATION
(EXAMPLE: FIFTH INPUT VALUE OF THIRD GENERATION IS $x_{35}$)

EVOLUTIONARY COMPUTATION

$x_1$: △   KEEP
$x_2$: ○   KEEP
$x_3$: ◎   COPY BEST
$x_4$: ×   REMOVE WORST

SELECT FROM INPUT VALUES "$x_{km}$"   ⌐S160

GENERATE INPUT VALUES "$x_{k+1m}$" OF NEXT GENERATION (CROSSING AND VARIATIONS)   ⌐S170

---

FIG. 17

STRUCTURE (IN CASE OF
OPTIMUM WIDTH CALCULATION)

$x_1=6$

$x_2=8$

$x_3=10$

$x_4=12$

EIGEN SOLUTION FOR EACH STRUCTURE

h(x)

$A_{n1}$

$h_1(z)$

$g(x_1)$

0  $z_1$

$A_{n2}$

$h_2(z)$

$g(x_2)$

0  $z_2$

$A_{n3}$

$h_3(z)$

$g(x_3)$

0  $z_3$

$A_{n4}$

$h_4(z)$

$g(x_4)$

0  $z_4$

SAW INTENSITY DISTRIBUTION FOR EACH STRUCTURE

$A_L$

$f(x_1)$

1.0

0  POSITION

$A_L$

$f(x_2)$

1.2

0  POSITION

$A_L$

$f(x_3)$

1.4

0  POSITION

$A_L$

$f(x_4)$

0.8

0  POSITION

PERFORMANCE $f(x)$

1.4
1.2
1.0
0.8

0  6  8  10  12  x

IN THIS CASE, HIGHEST
PERFORMANCE VALUE $f(x)$
AROUND WIDTH x = 10

# FIG. 18

START

INPUT A PLURALITY OF INPUT VALUES "$x_{km}$" (STRUCTURE/DESIGN VALUES) TO BE DESIGNED — S210

CALCULATE OPERATING CONDITION INHERENT TO EACH INPUT VALUE (SEARCH EIGEN SOLUTION AND EIGEN ACTION FROM ENTIRE RANGE) — S220

DECIDE EIGEN SOLUTION AND EIGEN ACTION — S230

CUMULATIVELY SAVE INPUT VALUES TO EIGEN SOLUTIONS — S240

CALCULATE PERFORMANCE OF EACH INPUT VALUE — S250

EVALUATE EACH INPUT VALUE TO PERFORMANCE — S260

S270
DOES CURRENT GENERATION EXCEED THRESHOLD VALUE?

NO → S280 SELECT FROM INPUT VALUES "$x_{km}$"

S290 GENERATE INPUT VALUES "$x_{k+1m}$" OF NEXT GENERATION (CROSSING AND VARIATIONS)

YES S300
GENERATE LEARNING MODEL FROM THE SAVED INPUT VALUES TO EIGEN SOLUTIONS

END

# FIG. 19

START

INPUT A PLURALITY OF INPUT VALUES "$x_{km}$" (STRUCTURE/DESIGN VALUES) TO BE DESIGNED ⟿ S310

ESTIMATE SOLUTION CANDIDATE RANGE FOR EIGEN SOLUTIONS FOR INPUT VALUES BY USING LEARNING MODEL ⟿ S320

PREDICT EIGEN SOLUTIONS IN SOLUTION CANDIDATE RANGE ⟿ S330

S340
HAS PREDICTION OF EIGEN SOLUTIONS SUCCEEDED? — YES

NO

CALCULATE OPERATING CONDITION INHERENT TO EACH INPUT VALUE (SEARCH EIGEN SOLUTION AND EIGEN ACTION FROM ENTIRE RANGE) ⟿ S350

DECIDE EIGEN SOLUTION AND EIGEN ACTION ⟿ S360

CALCULATE PERFORMANCE OF EACH INPUT VALUE ⟿ S370

EVALUATE EACH INPUT VALUE TO PERFORMANCE ⟿ S380

S390
SATISFY END CONDITION?

END CONDITION : "NO"

SELECT FROM INPUT VALUES "$x_{km}$" — S400

GENERATE INPUT VALUES "$x_{k+1m}$" OF NEXT GENERATION (CROSSING AND VARIATIONS) — S410

END CONDITION : "YES"

SELECT OPTIMUM INPUT VALUE ⟿ S420

END

Europäisches
Patentamt

European
Patent Office

Office européen
des brevets

## EUROPEAN SEARCH REPORT

Application Number

EP 20 19 5346

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | J. YAOCHU: "Surrogate-assisted evolutionary computation: Recent advances and future challenges", SWARM AND EVOLUTIONARY COMPUTATION, vol. 1, no. 2, 6 June 2011 (2011-06-06), pages 61-70, XP055776273, DOI: 10.1016/j.swevo.2011.05.001 * sections 3, 5 and 6 * | 1-8 | INV. G06N3/12 G06N3/08 ADD. G06F30/30 |
| A,D | Y. TSUNODA ET AL: "Neural-network assistance to calculate precise eigenvalue for fitness evaluation of real product design", PROCEEDINGS OF THE 2019 GENETIC AND EVOLUTIONARY COMPUTATION CONFERENCE COMPANION (GECCO'19), 13 July 2019 (2019-07-13), pages 405-406, XP058452286, DOI: 10.1145/3319619.3321884 * the whole document * | 1-8 | |
| A | M. FUJIWARA, M. MUNETOMO: "A surrogate-assisted selection scheme for genetic algorithms employing multi-layer neural networks", PROCEEDINGS OF THE 2018 GENETIC AND EVOLUTIONARY COMPUTATION CONFERENCE COMPANION (GECCO'18), 6 July 2018 (2018-07-06), pages 41-42, XP055730874, DOI: 10.1145/3205651.3208787 * the whole document * | 1-8 | TECHNICAL FIELDS SEARCHED (IPC)<br><br>G06N<br>G06F |

-/--

The present search report has been drawn up for all claims

| Place of search | Date of completion of the search | Examiner |
|---|---|---|
| The Hague | 16 February 2021 | Douarche, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

Application Number

EP 20 19 5346

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | P. K. S. NAIN, K. DEB: "Computationally effective search and optimization procedure using coarse to fine approximations", PROCEEDINGS OF THE 2003 CONGRESS ON EVOLUTIONARY COMPUTATION (CEC'03), vol. 3, 8 December 2003 (2003-12-08), pages 2081-2088, XP010707083, DOI: 10.1109/CEC.2003.1299929 * the whole document * ----- | 1-8 | |

TECHNICAL FIELDS
SEARCHED      (IPC)

The present search report has been drawn up for all claims

| Place of search | Date of completion of the search | Examiner |
|---|---|---|
| The Hague | 16 February 2021 | Douarche, Nicolas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002230514 A

- JP 2002245434 A

**Non-patent literature cited in the description**

- **YUKITO TSUNODA et al.** Neural-network assistance to calculate precise eigenvalue for fitness evaluation of real product design. *GECCO2019,* 2019, 405-406